(19) Europäisches Patentamt
European Patent Office
Office européen des brevets

(11) **EP 4 629 513 A1**

(12) **EUROPEAN PATENT APPLICATION**
published in accordance with Art. 153(4) EPC

(43) Date of publication:
**08.10.2025 Bulletin 2025/41**

(21) Application number: **23899760.5**

(22) Date of filing: **21.11.2023**

(51) International Patent Classification (IPC):
**H03M 13/13** (2006.01)

(52) Cooperative Patent Classification (CPC):
**H03M 13/13; H04L 1/00**

(86) International application number:
**PCT/CN2023/132939**

(87) International publication number:
**WO 2024/120181 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **06.12.2022 CN 202211557955**

(71) Applicant: **ZTE Corporation**
**Shenzhen, Guangdong 518057 (CN)**

(72) Inventors:
• **ZHAO, Wei**
 **Shenzhen, Guangdong 518057 (CN)**
• **LIANG, Chulong**
 **Shenzhen, Guangdong 518057 (CN)**
• **XU, Jin**
 **Shenzhen, Guangdong 518057 (CN)**
• **LI, Liguang**
 **Shenzhen, Guangdong 518057 (CN)**

(74) Representative: **Savi, Massimiliano et al**
**Notarbartolo & Gervasi S.p.A.**
**Viale Achille Papa, 30**
**20149 Milano (IT)**

(54) **DATA PROCESSING METHOD, DEVICE, AND STORAGE MEDIUM**

(57)    Disclosed in the present application is a data processing method, comprising: acquiring an information bit sequence, wherein the information bit sequence comprises K information bits, and K is an integer greater than 0; encoding the information sequence according to at least one of a first encoding parameter, a quantized weight value sequence and a reliability threshold, so as to obtain au encoded data sequence, wherein the encoded data sequence comprises N pieces of encoded data, N is an integer greater than K, the quantized weight value sequence comprises n quantized weight values, N represents the number of polarized sub-channels, and N is less than or equal to the n-th power of 2; and transmitting the encoded data sequence.

FIG. 3

```
k = K - 1;
u = [a₀, a₁,…, a_{K-1},0,…,0];
For i = N-1, N-2, N-3,…, 1, 0
    If   F = 1 && k ≥ 0
            uᵢ = u_k;
            k = k - 1;
    Else
            uᵢ = 0;
    End
End
```

EP 4 629 513 A1

**Description**

**CROSS-REFERENCE TO RELATED APPLICATION**

The present disclosure is filed on the basis of Chinese patent application No. 202211557955.8 filed December 06, 2022, and claims priority to the Chinese patent application, the entire contents of which are incorporated herein by reference.

**TECHNICAL FIELD**

The present disclosure relates to the field of communication technologies, and in particular, to a data processing method, a device, and a storage medium.

**BACKGROUND**

Since having higher reliability in short codes, polar codes are adopted in 5th Generation Mobile Communication (5G) standards formulated by the 3rd Generation Partnership Project (3GPP) as encoding schemes for 5G NR control messages, specifically, Downlink Control Information (DCI) and Uplink Control Information (UCI) in control channels, and broadcast information carried by Physical Broadcast Channels (PBCHs).

A polar code sequence is used to indicate a bit selection order before polar coding, i.e., "bestchannel selection". To enable polar codes to support the flexible code length and code rate requirements of 5G NR control messages, a sufficiently practical subchannel reliability sorting sequence needs to be designed. A Polar Weight (PW) sequence demonstrates that a polar code sequence can be independent of channel parameters from the perspective of standardization and practicality, which makes the PW sequence exhibit desirable and stable performance under various code length and code rate configurations.

In practical applications, after polar weights are calculated, the polar weights may be sorted in ascending order, and then sequence numbers of input bits originally corresponding to the polar weights can be found, thus obtaining a PW sequence. If the PW sequence is calculated in real time, high precision is required in the calculation of polar weights, resulting in the consumption of a lot of memory transistors. If the PW sequence is acquired from a memory, a PW sequence having a size of $N_{max}$ needs to be stored in the memory. For a polar code having a number N of polarized subchannels, a sub-sequence formed by the first N elements is sequentially extracted from the PW sequence having a size of $N_{max}$ to form a reliability sorting sequence of N subchannels, where N is less than or equal to $N_{max}$. Although this method reduces the overhead of online computing resources, it increases the storage overhead.

**SUMMARY**

The present disclosure discloses a data processing method, a device, and a storage medium, to reduce the overhead of storage resources used in polar coding.

In accordance with a first aspect of the present disclosure, an embodiment provides a data processing method, including:

acquiring an information bit sequence, where the information bit sequence includes K information bits, and K is an integer greater than 0;

encoding the information bit sequence according to at least one of a first encoding parameter, a quantization weight value sequence, and a reliability threshold to obtain an encoded data sequence, where the encoded data sequence includes N pieces of encoded data, N is an integer greater than K, the quantization weight value sequence includes n quantization weight values, N represents a number of polarized subchannels, and N is less than or equal to an nth power of 2; and

sending the encoded data sequence.

In accordance with a second aspect of the present disclosure, an embodiment provides a data processing method, including:

receiving an encoded data sequence sent by a transmit end, where the encoded data sequence is obtained by: encoding an information bit sequence according to at least one of a first encoding parameter, a quantization weight value sequence, and a reliability threshold to obtain the encoded data sequence, where the information bit sequence includes K information bits, K is an integer greater than 0, the encoded data sequence includes N pieces of encoded data, N is an integer greater than K, the quantization weight value sequence includes n quantization weight values, N represents a number of polarized subchannels, and N is less than or equal to an $n^{th}$ power of 2.

In accordance with a third aspect of the present disclosure, an embodiment provides an electronic device, including:

at least one processor; and
at least one memory, configured for storing at least one program,
where the at least one program, when executed by the at least one processor, causes the at least one processor to implement the data processing method in accordance with the first aspect or the second aspect.

In accordance with a fourth aspect of the present disclosure, an embodiment provides a computer-readable storage medium, storing a processor-executable program, where the processor-executable program, when executed by a processor, causes the processor to implement the data processing method in accordance with the first aspect or the second aspect.

In accordance with a fifth aspect of the present disclosure, an embodiment provides a computer program product, including a computer program or a computer instruction stored in a computer-readable storage medium, where the computer program or computer instruction, when read from the computer-readable storage medium and executed by a processor of a computer device, causes the computer device to implement the data processing method in accordance with the first aspect or the second aspect.

According to the embodiments of the present disclosure, an information bit sequence including K information bits is encoded according to at least one of a first encoding parameter, a quantization weight value sequence, and a reliability threshold to obtain an encoded data sequence, where the encoded data sequence includes N pieces of encoded data, N is an integer greater than K, the quantization weight value sequence includes n quantization weight values, N represents a number of polarized subchannels, and N is less than or equal to an $n^{th}$ power of 2. As such, in specific implementations, an information sequence including information bits and frozen bits is obtained by online determining whether each subchannel transmits information bits or frozen bits, and then the information sequence is encoded to obtain an encoded data sequence. Whereby, the storage overhead is reduced, and the number of memory transistors required is reduced.

**BRIEF DESCRIPTION OF DRAWINGS**

FIG. 1a is a schematic diagram of a logic code for adding frozen bits;
FIG. 1b is a plot of polar transformation factors when N=16;
FIG. 2 is a schematic architectural diagram of a communication system to which embodiments of the present disclosure are applicable;
FIG. 3 is a schematic flowchart of a data processing method according to an embodiment of the present disclosure;
FIGS. 4 to 7 are each a schematic diagram of a logic code for updating an information and frozen bit sequence according to an embodiment of the present disclosure;
FIGS. 8 to 9 are each a schematic diagram of a logic code for serial encoding according to an embodiment of the present disclosure;
FIG. 10 is a schematic flowchart of another multimedia data processing method according to an embodiment of the present disclosure;
FIG. 11 is a schematic structural diagram of a data processing apparatus according to an embodiment of the present disclosure; and
FIG. 12 is a schematic structural diagram of an electronic device according to an embodiment of the present disclosure.

**DETAILED DESCRIPTION**

The present disclosure will be further described below in conjunction with the accompanying drawings of the specification and specific embodiments.

In the following descriptions, the term "some embodiments" describes subsets of all possible embodiments, but it may be understood that "some embodiments" may be the same subset or different subsets of all the possible embodiments, and can be combined with each other without conflict.

Unless otherwise defined, meanings of all technical and scientific terms used in this specification are the same as those usually understood by those having ordinary skills in the art to which the present disclosure belongs. Terms used in this specification are merely intended to describe objectives of the embodiments of the present disclosure, but are not intended to limit the present disclosure.

For ease of understanding of the schemes of the embodiments of the present disclosure, terms involved in the embodiments of the present disclosure will be explained first.

(1) Polar Weight (PW) sequence:

For the PW sequence, a formula for calculating reliability of a polarized subchannel corresponding to an index bit i is:

$$W_i = \sum_{j=0}^{n-1} B_j \cdot 2^{j/4} \text{ (Formula 1)}$$

where $W_i$ is a polar weight used on an $i^{th}$ input bit ($i^{th}$ subchannel); i represents a sequence number of the input bit, where for a polar code with a number of polarized subchannels being $N = 2^n$, i = 0, 1, 2, ..., N-2, N-1; N is a number of bits required to express the integer N in a binary form; a binary expression of i is i = $B_{n-1}B_{n-2}...B_2B_1B_0$, with $B_0$ being the lowest bit; and $B_j$ represents a $j^{th}$ bit corresponding to the integer i in the binary form and has a value of bit 0 or bit 1, where j = 0, 1, 2, ..., n-2, n-1.

It should be noted that a quantization weight value sequence $\beta = [\beta_{n-1}, \beta_{n-2}, ..., \beta_0]$ calculated according to a number of polarized subchannels $N_{max} = 2^n$ may be used for polar codes with a number of polarized subchannels being N = $2^t$, where t = n, n-1, n-2, ..., 1. For example, a quantization weight value sequence $\beta = [\beta_9, \beta_8, ..., \beta_0]$ is calculated according to n=10 and $N_{max}$=1024, and this configuration can be used for polar coding with a polarized subchannel number N = 1024, 512, 256, 128, ..., so N may be less than or equal to $2^n$. For convenience of description, in the scheme of the embodiments of the present disclosure, $N_{max}$ is described as N, and N = $2^n$.

Table 1 provides a PW sequence with N = 16, i.e., PW = [0, 1, 2, 4, 8, 3, 5, 6, 9, 10, 12, 7, 11, 13, 14, 15], where the first element "0" represents an index number of a subchannel with lowest reliability, and the last element "15" represents an index number of a subchannel with highest reliability.

Table 1 PW sequence having a length of N = 16

| $W_i$ | i | $W_i$ | i | $W_i$ | i | $W_i$ | i |
|---|---|---|---|---|---|---|---|
| 0.0000 | 0 | 1.6818 | 8 | 2.6818 | 9 | 3.8710 | 11 |
| 1.0000 | 1 | 2.1892 | 3 | 2.8710 | 10 | 4.0960 | 13 |
| 1.1892 | 2 | 2.4142 | 5 | 3.0960 | 12 | 4.2852 | 14 |
| 1.4142 | 4 | 2.6034 | 6 | 3.6034 | 7 | 5.2852 | 15 |

(2) Polar code encoding

Assuming that a = [$a_0$, $a_1$, ..., $a_{k-1}$], a is an information sequence having a length of K, and N is the number of polarized subchannels, a process of encoding the information sequence a into a codeword d = [$d_0$, $d_1$, ..., $d_{n-1}$] having a length of N is as follows.

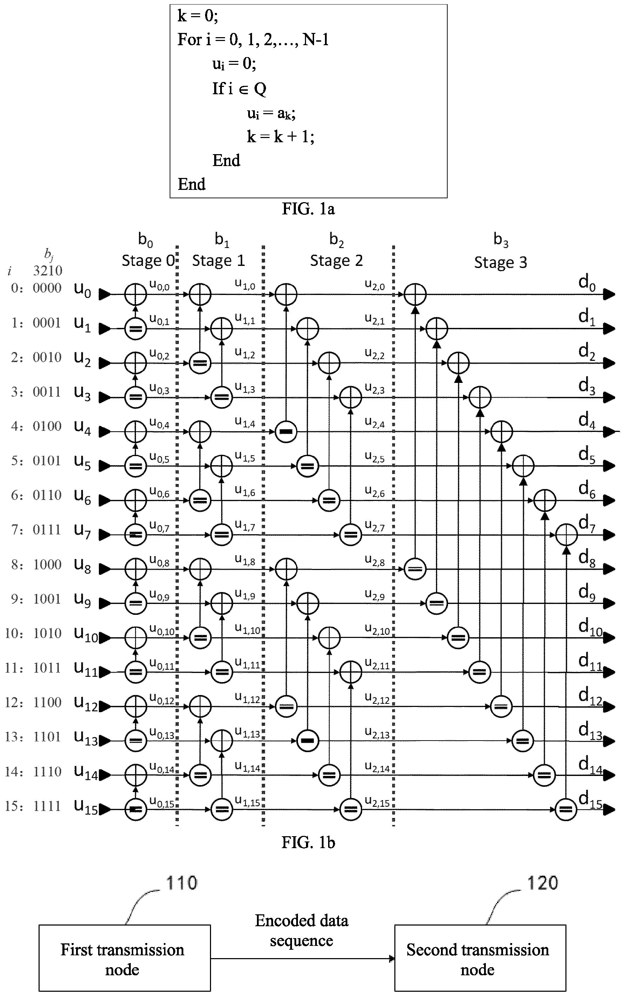

(1) Addition of frozen bits: An appropriate subchannel for carrying information bits and an appropriate subchannel for placing frozen bits are selected. N-K bits 0 are added to the information sequence a = [$a_0$, $a_1$, ..., $a_{k-1}$] to obtain a sequence u = [$u_0$, $u_1$, ..., $u_{n-1}$]. For example, the process of adding frozen bits may be implemented by a logic code shown in FIG. 1a.

Polar transformation: The sequence u and a polarization matrix $G_N$ of N rows and N columns are multiplied on GF(2) to obtain a codeword d = u·$G_N$, where $G_N = \begin{bmatrix} G_{N/2} & 0 \\ G_{N/2} & G_{N/2} \end{bmatrix}$, $G = \begin{bmatrix} 1 & 0 \\ 1 & 1 \end{bmatrix}$. FIG. 1b is a plot of polar transformation factors when N= 16.

In the 5G standard protocol TS 38.212 formulated by 3GPP, polar code sequences and corresponding reliability are given in a table. When the code length is N, a memory having $\log_2(N)$*N bits is required to store the polar code sequence. In the encoding process of encoding the information sequence a into a codeword d having a length of N, first, N-K bits 0 are added to the information sequence a = [$a_0$, $a_1$, ..., $a_{k-1}$] according to the polar code sequence to obtain a sequence u = [$u_0$, $u_1$, ..., $u_{N-1}$]; then the sequence u is used as an input of polarization transformation, to obtain the codeword d having a length of N through logical operation. To reduce the storage overhead, the present disclosure provides a data processing method for online calculating reliability of subchannels and determining a position of information bits.

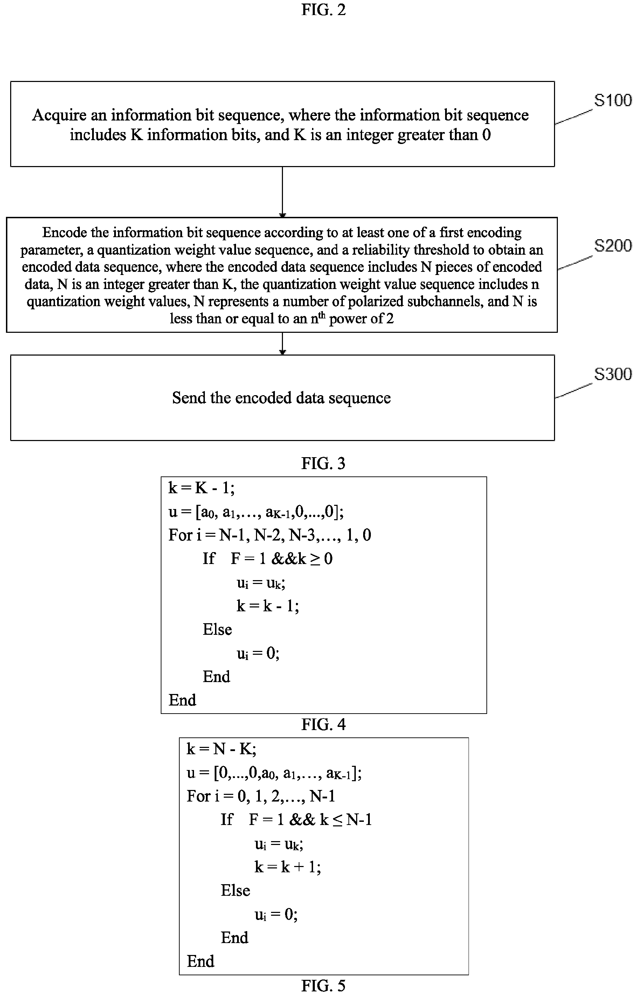

FIG. 2 is a schematic architectural diagram of a communication system to which embodiments of the present disclosure are applicable. The communication system shown in FIG. 2 includes a first transmission node 110 and a second transmission node 120. The first transmission node 110 sends an encoded data sequence to the second transmission node 120. The first transmission node 110 and the second transmission node 120 may include, but not limited to, one of the following devices: a Base Station (BS), an Access Point (AP), a NodeB, a generalized Node B (g NodeB), a Radio Network Controller (RNC), an Evolved NodeB (eNB), a Base Station Controller (BSC), a Base Transceiver Station (BTS), a Transceiver Function (TF), a radio router, a radio transceiver, a Basic Service Set (BSS), an Extended Service Set (ESS), or a Radio Base Station (RBS), which is not particularly limited in the embodiments of the present disclosure.

In a feasible implementation, the first transmission node 110 and the second transmission node 120 may be referred to as an access terminal, a User Equipment (UE), a subscriber unit, a subscriber station, a mobile station, a mobile, a remote station, a remote terminal, a mobile device, a user terminal, a wireless communication device, a user agent, or a user device. For example, the first transmission node 110 and the second transmission node 120 may be a cellular phone, a cordless telephone, a Session Initiation Protocol (SIP) telephone, a Wireless Local Loop (WLL) station, a Personal Digital Assistant (PDA), a handheld device with a wireless communication function, a computing device or other processing device connected to a wireless modem, a vehicle-mounted device, a wearable device, a terminal device in a 5G network or future evolved networks, etc., which is not limited in the embodiments of the present disclosure.

FIG. 3 is a schematic flowchart of a data processing method according to a first aspect of embodiments of the present disclosure. The data processing method can be applied to the first transmission node 110 shown in FIG. 2. As shown in FIG. 3, the data processing method includes the following steps S100-S300, which will be sequentially described below.

At S100, an information bit sequence is acquired, where the information bit sequence includes K information bits, and K is an integer greater than 0.

At S200, the information bit sequence is encoded according to at least one of a first encoding parameter, a quantization weight value sequence, and a reliability threshold to obtain an encoded data sequence, where the encoded data sequence includes N pieces of encoded data, N is an integer greater than K, the quantization weight value sequence includes n quantization weight values, N represents a number of polarized subchannels, and N is less than or equal to an $n^{th}$ power of 2.

At S300, the encoded data sequence is sent.

For example, the first encoding parameter includes at least one of:

(1) an information bit sequence size, which refers to the number of information bits included in the information bit sequence, where in the embodiments of the present disclosure, the number of information bits is represented by K, and K is an integer greater than 0;

(2) the number of polarized subchannels, which indicates the number of subchannels for transmitting a polar code, where in the embodiments of the present disclosure, the number of polarized subchannels is represented by N, N is a positive integer power of 2, and N is greater than K;

(3) a code rate, which refers to K/N, i.e., the ratio of the information bit sequence size K to the number N of polarized subchannels, where in the embodiments of the present disclosure, the code rate is represented by R;

(4) an information index number, which is used for indexing a serial number of an information bit in the information and frozen bit sequence, where in the embodiments of the present disclosure, the information index number is represented by k, and k is an integer greater than or equal to 0 and less than or equal to K-1, or k is an integer greater than or equal to N-K and less than or equal to N-1;

(5) a subchannel index number, which indicates a serial number of a subchannel of a polar code, where in the embodiments of the present disclosure, i is used to represent the subchannel index number, and i is an integer greater than or equal to 0 and less than N;

(6) a polar coding stage index number, which indicates a serial number of a polar coding stage, where in the embodiments of the present disclosure, stage 0, stage 1, ... are used to indicate the polar coding stage index number, and stage-1 is used to indicate a stage where the information and frozen bit sequence is obtained from the information bit sequence;

(7) a number of transport block bits TBS, which is a positive integer;

(8) a number of cyclic redundancy check bits, $L_{CRC}$, which is a positive integer; and

(9) a number of parity check bits, $L_{PC}$, which is a positive integer.

It can be understood that the first encoding parameter may be set according to specific application scenarios, which is not limited herein. Specific application principles of the above first encoding parameter will be described in the following embodiments and will not be described in detail here.

For example, the encoded data sequence in S200 may be obtained by performing the following steps S210 to S220.

At S210, frozen bits are added to the information bit sequence according to at least one of a first encoding parameter, a quantization weight value sequence, and a reliability threshold to obtain an encoded data sequence to obtain an information and frozen bit sequence, where the information and frozen bit sequence includes N bits.

At S220, the information and frozen bit sequence is encoded to obtain the encoded data sequence.

For example, for an inputted information bit sequence $a = [a_0, a_1, ..., a_{K-1}]$, N-K frozen bits are added to the K information bits of the information bit sequence a to obtain an information and frozen bit sequence $u = [u_0, u_1, ..., u_{n-1}]$. It can be understood that the information and frozen bit sequence u includes K information bits and N-K frozen bits, and the positions of the information bits and the frozen bits are determined according to at least one of the first encoding parameter, the quantization weight value sequence, and the reliability threshold.

For example, the information and frozen bit sequence in S210 may be obtained by performing the following steps S211 to S212.

At S211, frozen bits are added to the information bit sequence according to a preset rule to obtain an initial information and frozen bit sequence, where the information and frozen bit sequence includes N bits.

For example, the initial information and frozen bit sequence may be obtained in any of the following manners.

Manner 1: The information bits in the information bit sequence are sequentially set at the first K bits of the initial information and frozen bit sequence.

It can be understood that when the information bits in the information bit sequence $a = [a_0, a_1, ..., a_{K-1}]$ are sequentially set at the first K bits of the information and frozen bit sequence, an initial information and frozen bit sequence $u = [u_0, u_1, ..., u_{n-1}] = [a_0, a_1, ..., a_{K-1}, 0, ...,0]$ is obtained, where N represents the number of polarized subchannels and has a value which is a positive integer power of 2, K represents the number of information bits and has a value which is a positive integer, and K < N.

Manner 2: The information bits in the information bit sequence are sequentially set at the last K bits of the initial information and frozen bit sequence.

It can be understood that when the information bits in the information bit sequence $a = [a_0, a_1, ..., a_{K-1}]$ are sequentially set at the last K bits of the information and frozen bit sequence, an initial information and frozen bit sequence $u = [u_0, u_1, ..., u_{n-1}] = [0, ..., 0, a_0, a_1, ..., a_{k-1}]$ is obtained, where N represents the number of polarized subchannels and has a value which is a positive integer power of 2, K represents the number of information bits and has a value which is a positive integer, and K < N.

Manner 3: The information bits in the information bit sequence are set in reverse order at the first K bits of the initial information and frozen bit sequence.

It can be understood that when the information bits in the information bit sequence $a = [a_0, a_1, ..., a_{K-1}]$ are set in reverse order at the first K bits of the information and frozen bit sequence, an initial information and frozen bit sequence $u = [u_0, u_1, ..., u_{n-1}] = [a_{K-1}, a_{K-2}, ..., a_0, 0, ...,0]$ is obtained, where N represents the number of polarized subchannels and has a value which is a positive integer power of 2, K represents the number of information bits and has a value which is a positive integer, and K < N.

Manner 4: The information bits in the information bit sequence are set in reverse order at the last K bits of the initial information and frozen bit sequence.

It can be understood that when the information bits in the information bit sequence $a = [a_0, a_1, ..., a_{K-1}]$ are set in reverse order at the last K bits of the initial information and frozen bit sequence, an initial information and frozen bit sequence $u = [u_0, u_1, ..., u_{n-1}] = [0, ..., 0, a_{K-1}, a_{K-2}, ..., a_0]$ is obtained, where N represents the number of polarized subchannels and has a value which is a positive integer power of 2, K represents the number of information bits and has a value which is a positive integer, and K < N.

When the information bit sequence is initially stored in the information and frozen bit sequence in the above manner, the positions of the information bits in the information and frozen bit sequence can be adjusted according to the information index numbers and the information and frozen bit indications to obtain a final information and frozen bit sequence to be inputted to the polarized subchannels without requiring additional storage space to store the information bits, thereby saving the storage space.

At S212, the N polarized subchannels are sequentially traversed in ascending order or descending order of subchannel index numbers, and the following steps S2121 to S2123 are performed for the polarized subchannel currently being traversed.

At S2121, a subchannel reliability value of the polarized subchannel currently being traversed is determined according to the quantization weight value sequence.

At S2122, a frozen bit indication corresponding to the polarized subchannel currently being traversed is determined according to the reliability threshold and the subchannel reliability value.

At S2123, a value of a bit, which corresponds to the polarized subchannel currently being traversed, in the information and frozen bit sequence is determined according to the frozen bit indication, and the information and frozen bit sequence is updated according to the value of the bit.

For example, the subchannel index numbers corresponding to the N polarized subchannels are arranged in descending order or in ascending order to obtain a subchannel index number sequence [0, 1, ..., N-1] or [N-1, N-2, ..., 0]. Then, the polarized subchannels corresponding to the subchannel index numbers in the subchannel index number sequence are traversed. For each polarized subchannel being traversed, a subchannel reliability value and a frozen bit indication corresponding to the polarized subchannel currently being traversed are determined, then it is determined according to the frozen bit indication whether bits carried by the polarized subchannel currently being traversed are information bits or frozen bits, and the information and frozen bit sequence is updated. When the traversal of the N polarized subchannels is completed, a final information and frozen bit sequence is obtained.

It should be noted that in the embodiments of the present disclosure, $\beta$ is used to represent the quantization weight value sequence, $\beta$ includes n quantization weight values, a $j^{th}$ quantization weight value in $\beta$ represents a quantization weight value corresponding to a $j^{th}$ bit in a binary expression of the subchannel index number, and j is any integer from 0 to n-1. For example, the subchannel index number i is expressed in binary form as $i = B_{n-1}B_{n-2}...B_2B_1B_0$, where a $0^{th}$ bit $B_0$ is the lowest bit, and an $(n-1)^{th}$ bit $B_{n-1}$ is the highest bit, $\beta_j$ is the quantization weight value corresponding to $B_j$, $B_j$ represents a $j^{th}$ bit in the binary expression of the subchannel index number i, $j \in \{0, 1, ..., n-1\}$, $n = \log_2 N$, and N is the number of polarized subchannels.

It can be understood that n quantization weight values in the quantization weight value sequence are arranged in ascending order or descending order. When arranged in ascending order, the quantization weight value sequence $\beta$ may be expressed as: $\beta = [\beta_0, \beta_1, ..., \beta_{n-1}]$. When arranged in descending order, the quantization weight value sequence $\beta$ may be expressed as: $\beta = [\beta_{n-1}, \beta_{n-2}, ..., \beta_0]$.

It can be understood that a sum of all quantization weight values in the quantization weight value sequence $\beta$ is less than a first value. M is used to represent the first value, i.e., $\beta_{n-1}+\beta_{n-2}+...+\beta_0 < M$. It should be noted that M is a positive integer power of 2. For example, the first value includes one of: 256, 512, 1024, 2048, or 4096.

It can be understood that the quantization weight value sequence may be determined in one of the following two manners.

In a first manner, the quantization weight value sequence may be preset, and the preset quantization weight value sequence $\beta = [\beta_{n-1}, \beta_{n-2}, ..., \beta_0]$ satisfies $\beta n-1+\beta n-2+...+\beta 0 < M$, where M is a positive integer power of 2.

In a second manner, the quantization weight value sequence is determined according to a constraint condition that a number of differences between a quantized polar weight sequence (quantized PW sequence) obtained by the quantization weight value sequence and a polar weight sequence (PW sequence) is not greater than a second value D. The second value D is an integer greater than or equal to 0 and less than or equal to N. It is assumed that $M = 2^1$, 1 being a positive integer. The storage of each reliability threshold requires only a maximum of 1 bit when $M = 2^1$.

For example, the quantization weight value sequence $\beta$ includes one of:

$\beta$ = [96, 81, 68, 57, 48, 40, 34, 28, 24, 20]; or
$\beta$ = [197, 165, 139, 116, 98, 82, 68, 58, 49, 41]; or
$\beta$ = [389, 327, 275, 231, 194, 163, 137, 115, 97, 82]; or
$\beta$ = [780, 656, 552, 464, 390, 328, 276, 232, 195, 164]; or
$\beta$ = [51, 43, 36, 30, 25, 21, 18, 15, 13]; or
$\beta$ = [101, 85, 71, 60, 50, 42, 35,30, 25]; or
$\beta$ = [206, 173, 145, 122, 102, 86, 73, 61, 51]; or
$\beta$ = [480, 404, 340, 286, 240, 202, 170, 143, 120].

For example, the reliability threshold in the embodiments of the present disclosure may be obtained from a preset mapping relationship according to an index value. The index value is determined according to, for example, but not limited to, at least one of the number K of information bits, the number N of polarized subchannels, and a code rate R. The mapping relationship includes, but not limited to, at least one of: a mapping formula, a mapping table, or a mapping graph. Of course, the mapping relationship may also be other expressions indicating a correspondence, which is not limited in the embodiments of the present disclosure.

In a possible implementation, for the information bit sequence $a = [a_0, a_1,..., a_{k-1}]$, the reliability value of the $i^{th}$ subchannel may be calculated according to the quantization weight value sequence, the reliability threshold may be obtained according to the mapping relationship, and it can be determined whether the $i^{th}$ subchannel carries information bits by comparing the reliability value of the $i^{th}$ subchannel with the reliability threshold. Thus the information and frozen bit sequence $u = [u_0, u_1,..., u_{N-1}]$ can be determined, and then the information and frozen bit sequence u is encoded to obtain encoded data $d = [d_0, d_1, ..., d_{N-1}]$.

It can be understood that the information bit sequence and the information and frozen bit sequence satisfy the following mapping relationship: $u_{f1}(j) = a_{f2(j)}$, where f1 is a function of j, and is determined according to, for example, but not limited to, f2(j), an information and frozen bit indication, and an information index number, and $fl(j) \in \{0, 1, ..., N-1\}$; f2 is a function of j, including, but not limited to, $f(j)=j$ and $f(j)=K-j$; $f2(j) \in \{0, 1, ..., K-1\}$; and $j = 0, 1, ..., K-1$. Based on the above mapping relationship, elements in the information and frozen bit sequence $u = [u_0, u_1, u_{n-1}]$ can be determined according to the obtained information bit sequence $a = [a_0, a_1, ..., a_{k-1}]$.

The data processing method provided in the embodiments of the present disclosure will be described in detail below through specific examples.

Example One:

A reliability threshold $w_{th}$ is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a mapping table (hereinafter referred to as a reliability threshold table).

For example, N is a positive integer power of 2, including, but not limited to, one of: 32, 64, 128, 256, 512, or 1024; K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299; $w_{K,N}<M$, M is a positive integer power of 2, and a value of M includes, but not limited to, one of: 256, 512, 1024, 2048, or 4096. Table 2 is a feasible reliability threshold table indexed by K and N. In some other examples, the reliability threshold table includes at least one row or at least one column in Table 2. It can be understood that Table 2 is merely a feasible mapping form of the reliability threshold table, and the reliability threshold table may also be in other mapping forms, which is not particularly limited in the embodiments of the present disclosure.

Table 2 Reliability threshold table indexed by K and N

| K / N | 32 | 64 | 128 | 256 | 512 | 1024 |
|---|---|---|---|---|---|---|
| 25 | $W_{25,32}$ | $W_{25,64}$ | $W_{25,128}$ | $W_{25,256}$ | $W_{25,512}$ | $W_{25,1024}$ |
| 35 | NaN | $W_{35,64}$ | $W_{35,128}$ | $W_{35,256}$ | $W_{35,512}$ | $W_{35,1024}$ |
| 43 | NaN | $W_{43,64}$ | $W_{43,128}$ | $W_{43,256}$ | $W_{43,512}$ | $W_{43,1024}$ |
| 51 | NaN | $W_{51,64}$ | $W_{51,128}$ | $W_{51,256}$ | $W_{51,512}$ | $W_{51,1024}$ |
| 59 | NaN | $W_{59,64}$ | $W_{59,128}$ | $W_{59,256}$ | $W_{59,512}$ | $W_{59,1024}$ |
| 67 | NaN | NaN | $W_{67,128}$ | $W_{67,256}$ | $W_{67,512}$ | $W_{67,1024}$ |
| 75 | NaN | NaN | $W_{75,128}$ | $W_{75,256}$ | $W_{75,512}$ | $W_{75,1024}$ |
| 83 | NaN | NaN | $W_{83,128}$ | $W_{83,256}$ | $W_{83,512}$ | $W_{83,1024}$ |
| 91 | NaN | NaN | $W_{91,128}$ | $W_{91,256}$ | $W_{91,512}$ | $W_{91,1024}$ |
| 99 | NaN | NaN | $W_{99,128}$ | $W_{99,256}$ | $W_{99,512}$ | $W_{99,1024}$ |
| 107 | NaN | NaN | $W_{107,128}$ | $W_{107,256}$ | $W_{107,512}$ | $W_{107,1024}$ |
| 115 | NaN | NaN | $W_{115,128}$ | $W_{115,256}$ | $W_{115,512}$ | $W_{115,1024}$ |
| 123 | NaN | NaN | $W_{123,128}$ | $W_{123,256}$ | $W_{123,512}$ | $W_{123,1024}$ |
| 131 | NaN | NaN | NaN | $W_{131,256}$ | $W_{131,512}$ | $W_{131,1024}$ |
| 139 | NaN | NaN | NaN | $W_{139,256}$ | $W_{139,512}$ | $W_{139,1024}$ |
| 147 | NaN | NaN | NaN | $W_{147,256}$ | $W_{147,512}$ | $W_{147,1024}$ |
| 155 | NaN | NaN | NaN | $W_{155,256}$ | $W_{155,512}$ | $W_{155,1024}$ |
| 163 | NaN | NaN | NaN | $W_{163,256}$ | $W_{163,512}$ | $W_{163,1024}$ |
| 171 | NaN | NaN | NaN | $W_{171,256}$ | $W_{171,512}$ | $W_{171,1024}$ |
| 179 | NaN | NaN | NaN | $W_{179,256}$ | $W_{179,512}$ | $W_{179,1024}$ |
| 187 | NaN | NaN | NaN | $W_{187,256}$ | $W_{187,512}$ | $W_{187,1024}$ |
| 195 | NaN | NaN | NaN | $W_{195,256}$ | $W_{195,512}$ | $W_{195,1024}$ |

(continued)

| K / N | 32 | 64 | 128 | 256 | 512 | 1024 |
|---|---|---|---|---|---|---|
| 203 | NaN | NaN | NaN | $W_{203,256}$ | $W_{203,512}$ | $W_{203,1024}$ |
| 219 | NaN | NaN | NaN | $W_{219,256}$ | $W_{219,512}$ | $W_{219,1024}$ |
| 235 | NaN | NaN | NaN | $W_{235,256}$ | $W_{235,512}$ | $W_{235,1024}$ |
| 251 | NaN | NaN | NaN | $W_{251,256}$ | $W_{251,512}$ | $W_{251,1024}$ |
| 267 | NaN | NaN | NaN | NaN | $W_{267,512}$ | $W_{267,1024}$ |
| 283 | NaN | NaN | NaN | NaN | $W_{283,512}$ | $W_{283,1024}$ |
| 299 | NaN | NaN | NaN | NaN | $W_{299,512}$ | $W_{299,1024}$ |

It can be understood that the relationship between the reliability threshold and the number K of information bits and the relationship between the reliability threshold and the number N of polarized subchannels can be obtained from the reliability threshold table, and a reliability threshold corresponding to a combination of a value of K and a value of N includes one of: NaN and $w_{k,n}$, where "NaN" is a null value, indicating that there is no reliability threshold corresponding to the current combination of K and N, and $w_{K,N}$ is a reliability threshold corresponding to the combination of K and N.

It can be understood that when the value of K is greater than or equal to the value of N, the reliability threshold corresponding to the value of K and the value of N is NaN, where NaN indicates that the reliability threshold is a null value.

It can also be understood that when the value of K is less than the value of N, the reliability threshold corresponding to the value of K and the value of N is $w_{K,N}$. In a feasible implementation, a value of $w_{K,N}$ is determined by performing the following steps S310 to S313.

At S310, a subchannel reliability value corresponding to each of the polarized subchannels is calculated according to the quantization weight value sequence β and the subchannel index numbers i respectively corresponding to the polarized subchannels.

At S311, a subchannel reliability sequence is obtained according to the subchannel reliability values corresponding to the N polarized subchannels.

At S312, K largest subchannel reliability values are selected from the subchannel reliability sequence.

At S313, the smallest subchannel reliability value is selected as $w_{K,N}$ from the K largest subchannel reliability values.

In other words, N subchannel reliability values $w' = [w'_0, w'_1, ..., w'_{N-1}]$ are calculated according to the quantization weight value sequence β and the subchannel index number i; and K largest reliability values are selected from w', and then the smallest value $w_{N-K}$ is selected from the K largest reliability values, where $w_{N-K}$ is an element value at a position (N, K) in the reliability threshold table.

For example, the reliability threshold $w'_i$ of the $i^{th}$ subchannel is determined according to the following formula 2:

$$w'_i = \sum_{j=0}^{n-1} B_j \cdot \beta_j \quad \text{(Formula 2)}$$

where $n = \log_2 N$ represents a number of bits required to express the integer N in a binary form; i is an integer greater than or equal to 0 and less than N, i is expressed in binary form, and $i = B_{n-1}B_{n-2}...B_2B_1B_0$; and $B_j$ represents a $j^{th}$ bit corresponding to the integer i in the binary form.

It can be understood that, a value of N corresponds to two different values of K, K1 and K2. When K1 is less than K2, $w_{K1,N}$ is greater than $w_{K2,N}$, $w_{K1,N}$ represents a reliability threshold corresponding to the value of K1 and the value of N, and $w_{K2,N}$ represents a reliability threshold corresponding to the value of K2 and the value of N.

A value of K corresponds to two different values of N, N1 and N2. When N1 is less than N2, $w_{K,N1}$ is less than $w_{K,N2}$, $w_{K,N1}$ represents a reliability threshold corresponding to the value of K and the value of N1, and $w_{K,N2}$ represents a reliability threshold corresponding to the value of K and the value of N2.

Example Two:

A reliability threshold $w_{th}$ is obtained from a preset mapping relationship according to an index value. In this example, the index value is determined according to a value of a number K of information bits and a value of a code rate R, and a mapping relationship between the number K of information bits, the code rate R, and the reliability threshold is recorded through a mapping table (hereinafter referred to as a reliability threshold table).

For example, R is a real number greater than 0 and less than 1, including, but not limited to, one of: 25/32, 25/64, 25/128, 25/256, 25/512, 25/1024, 35/64, 35/128, 35/256, 35/512, 35/1024, 43/64, 43/128, 43/256, 43/512, 43/1024, 51/64, 51/128, 51/256, 51/512, 51/1024, 59/64, 59/128, 59/256, 59/512, or 59/1024; K is a positive integer, including, but not limited to, one of: 25, 35, 43, 51, or 59; and $w_{K,R}<M$, M is a positive integer power of 2, and a value of M includes, but not limited to, one of: 256, 512, 1024, 2048, or 4096. A reliability threshold table indexed by K and R is shown in Table 3. In some other examples, the reliability threshold table includes at least one row or at least one column in Table 3. It can be understood that Table 3 is merely a feasible mapping form of the reliability threshold table, and the reliability threshold table may also be in other mapping forms, which is not particularly limited in the embodiments of the present disclosure.

Table 3 Reliability threshold table indexed by K and R

| K=25 | R | 25/32 | 25/64 | 25/128 | 25/256 | 25/512 | 25/1024 |
|------|---|-------|-------|--------|--------|--------|---------|
| | $w_{K,R}$ | $w_{25,25/32}$ | $w_{25,25/64}$ | $w_{25,25/128}$ | $w_{25,25/256}$ | $w_{25,25/512}$ | $w_{25,25/1024}$ |
| K=35 | R | 35/32 | 35/64 | 35/128 | 35/256 | 35/512 | 35/1024 |
| | $w_{K,R}$ | NaN | $w_{35,35/64}$ | $w_{35,35/128}$ | $w_{35,35/256}$ | $w_{35,35/512}$ | $w_{35,35/1024}$ |
| K=43 | R | 43/32 | 43/64 | 43/128 | 43/256 | 43/512 | 43/1024 |
| | $w_{K,R}$ | NaN | $w_{43,43/64}$ | $w_{43,43/128}$ | $w_{43,43/256}$ | $w_{43,43/512}$ | $w_{43,43/1024}$ |
| K=51 | R | 51/32 | 51/64 | 51/128 | 51/256 | 51/512 | 51/1024 |
| | $w_{K,R}$ | NaN | $w_{51,51/64}$ | $w_{51,51/128}$ | $w_{51,51/256}$ | $w_{51,51/512}$ | $w_{51,51/1024}$ |
| K=59 | R | 59/32 | 59/64 | 59/128 | 59/256 | 59/512 | 59/1024 |
| | 59 | NaN | $w_{59,59/64}$ | $w_{59,59/128}$ | $w_{59,59/256}$ | $w_{59,59/512}$ | $w_{59,59/1024}$ |

It can be understood that the relationship between the reliability threshold and the number K of information bits and the relationship between the reliability threshold and the code rate R can be obtained from the reliability threshold table. A reliability threshold corresponding to a combination of a value of K and a value of N includes one of: NaN and $w_{K,R}$, where "NaN" is a null value, indicating that there is no reliability threshold corresponding to the current combination of K and R, and $w_{K,R}$ is a reliability threshold corresponding to the combination of K and R.

It is understood that when K is equal to or greater than K/R, the reliability threshold corresponding to the value of K and the value of R is NaN, where NaN indicates that the reliability threshold is a null value.

It can also be understood that when K is less than K/R, the reliability threshold corresponding to the value of K and the value of R is $w_{K,R}$. In a feasible implementation, a value of $w_{K,R}$ is determined by performing the following steps S320 to S323.

At S320, a value of N is determined according to a value of K and a value of R.

At S321, a subchannel reliability value corresponding to each of the polarized subchannels is calculated according to the quantization weight value sequence β and the subchannel index numbers i respectively corresponding to the N polarized subchannels.

At S322, a subchannel reliability sequence is obtained according to the subchannel reliability values corresponding to the N polarized subchannels, and K largest subchannel reliability values are selected from the subchannel reliability sequence.

At S323, the smallest subchannel reliability value is selected as $w_{K,R}$ from the K largest subchannel reliability values.

In other words, first, a number N of polarized subchannels is determined according to the number K of information bits and the code rate R. For example, N = K/R; then, N subchannel reliability values $w' = [w'_0, w'_1, ..., w'_{N-1}]$ are calculated according to the quantization weight value sequence β and the subchannel index number i; and K largest reliability values are selected from w', and then the smallest value $w_{N-K}$ is selected from the K largest reliability values, where $w_{N-K}$ is an element value at a position (R, K) in the reliability threshold table.

It can be understood that a value of K corresponds to two different values of R, R1 and R2. When R1 is less than R2, $w_{K,R1}$ is greater than $w_{K,R2}$, $w_{K,R1}$ represents a reliability threshold corresponding to the value of K and the value of R1, and $w_{K,R2}$ represents a reliability threshold corresponding to the value of K and the value of R2.

Example Three:

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [96, 81, 68, 57, 48, 40, 34, 28, 24, 20]$, and n = 10; N is a positive integer power of 2, including, but not limited to, one of: 32, 64, 128, 256, 512, or 1024; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 4 provides a specific example of the reliability threshold table. In another example, the reliability threshold table includes at least one row or at least one column in Table 4.

Table 4 Reliability threshold table when $\beta = [96, 81, 68, 57, 48, 40, 34, 28, 24, 20]$

| K N | 32 | 64 | 128 | 256 | 512 | 1024 |
|---|---|---|---|---|---|---|
| 25 | 48 | 110 | 170 | 241 | 322 | 418 |
| 35 | NaN | 92 | 159 | 228 | 312 | 408 |
| 43 | NaN | 78 | 149 | 221 | 303 | 400 |
| 51 | NaN | 62 | 140 | 213 | 295 | 394 |
| 59 | NaN | 40 | 131 | 207 | 291 | 387 |
| 67 | NaN | NaN | 122 | 200 | 284 | 381 |
| 75 | NaN | NaN | 115 | 194 | 279 | 376 |
| 83 | NaN | NaN | 106 | 189 | 275 | 372 |
| 91 | NaN | NaN | 97 | 183 | 271 | 368 |
| 99 | NaN | NaN | 86 | 178 | 266 | 365 |
| 107 | NaN | NaN | 76 | 173 | 261 | 360 |
| 115 | NaN | NaN | 60 | 169 | 258 | 356 |
| 123 | NaN | NaN | 40 | 163 | 254 | 353 |
| 131 | NaN | NaN | NaN | 159 | 251 | 351 |
| 139 | NaN | NaN | NaN | 153 | 247 | 347 |
| 147 | NaN | NaN | NaN | 149 | 243 | 344 |
| 155 | NaN | NaN | NaN | 143 | 240 | 342 |
| 163 | NaN | NaN | NaN | 139 | 236 | 338 |
| 171 | NaN | NaN | NaN | 132 | 233 | 336 |
| 179 | NaN | NaN | NaN | 126 | 230 | 332 |
| 187 | NaN | NaN | NaN | 121 | 227 | 330 |
| 195 | NaN | NaN | NaN | 116 | 223 | 327 |
| 203 | NaN | NaN | NaN | 108 | 221 | 326 |
| 219 | NaN | NaN | NaN | 92 | 214 | 320 |
| 235 | NaN | NaN | NaN | 74 | 207 | 316 |
| 251 | NaN | NaN | NaN | 40 | 202 | 311 |
| 267 | NaN | NaN | NaN | NaN | 197 | 307 |
| 283 | NaN | NaN | NaN | NaN | 190 | 303 |
| 299 | NaN | NaN | NaN | NaN | 183 | 298 |

Example Four:

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [197, 165, 139, 116, 98, 82, 68, 58, 49, 41]$, and n = 10; N is a positive integer power of 2, including, but not limited to, one of: 32, 64, 128, 256, 512, or 1024; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 5 provides a specific example of the reliability threshold table. In another example, the reliability threshold table includes at least one row or at least one column in Table 5.

Table 5 Reliability threshold table when $\beta = [197, 165, 139, 116, 98, 82, 68, 58, 49, 41]$

| K<br>N | 32 | 64 | 128 | 256 | 512 | 1024 |
|---|---|---|---|---|---|---|
| 25 | 99 | 224 | 347 | 493 | 658 | 855 |
| 35 | NaN | 189 | 323 | 467 | 635 | 832 |
| 43 | NaN | 158 | 304 | 452 | 618 | 816 |
| 51 | NaN | 126 | 287 | 436 | 602 | 805 |
| 59 | NaN | 82 | 266 | 422 | 593 | 790 |
| 67 | NaN | NaN | 249 | 409 | 579 | 780 |
| 75 | NaN | NaN | 233 | 396 | 569 | 767 |
| 83 | NaN | NaN | 215 | 386 | 560 | 758 |
| 91 | NaN | NaN | 198 | 373 | 552 | 751 |
| 99 | NaN | NaN | 175 | 363 | 543 | 747 |
| 107 | NaN | NaN | 156 | 354 | 534 | 735 |
| 115 | NaN | NaN | 123 | 345 | 527 | 727 |
| 123 | NaN | NaN | 82 | 332 | 519 | 722 |
| 131 | NaN | NaN | NaN | 323 | 511 | 716 |
| 139 | NaN | NaN | NaN | 313 | 503 | 709 |
| 147 | NaN | NaN | NaN | 304 | 495 | 702 |
| 155 | NaN | NaN | NaN | 291 | 488 | 699 |
| 163 | NaN | NaN | NaN | 282 | 480 | 691 |
| 171 | NaN | NaN | NaN | 270 | 476 | 685 |
| 179 | NaN | NaN | NaN | 256 | 470 | 677 |
| 187 | NaN | NaN | NaN | 247 | 462 | 675 |
| 195 | NaN | NaN | NaN | 237 | 454 | 668 |
| 203 | NaN | NaN | NaN | 221 | 452 | 666 |
| 219 | NaN | NaN | NaN | 189 | 436 | 653 |
| 235 | NaN | NaN | NaN | 150 | 422 | 644 |
| 251 | NaN | NaN | NaN | 82 | 412 | 635 |
| 267 | NaN | NaN | NaN | NaN | 402 | 627 |
| 283 | NaN | NaN | NaN | NaN | 388 | 618 |

(continued)

| K N | 32 | 64 | 128 | 256 | 512 | 1024 |
|---|---|---|---|---|---|---|
| 299 | NaN | NaN | NaN | NaN | 373 | 609 |

Example Five:

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [389, 327, 275, 231, 194, 163, 137, 115, 97, 82]$, and n = 10; N is a positive integer power of 2, including, but not limited to, one of: 32, 64, 128, 256, 512, or 1024; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 6 provides a specific example of the reliability threshold table. In another example, the reliability threshold table includes at least one row or at least one column in Table 6.

Table 6 Reliability threshold table when $\beta = [389, 327, 275, 231, 194, 163, 137, 115, 97, 82]$

| K N | 32 | 64 | 128 | 256 | 512 | 1024 |
|---|---|---|---|---|---|---|
| 25 | 197 | 446 | 691 | 978 | 1305 | 1694 |
| 35 | NaN | 375 | 644 | 926 | 1261 | 1650 |
| 43 | NaN | 316 | 604 | 897 | 1227 | 1619 |
| 51 | NaN | 252 | 569 | 866 | 1197 | 1595 |
| 59 | NaN | 163 | 531 | 840 | 1178 | 1568 |
| 67 | NaN | NaN | 497 | 811 | 1152 | 1545 |
| 75 | NaN | NaN | 465 | 787 | 1131 | 1524 |
| 83 | NaN | NaN | 428 | 767 | 1112 | 1506 |
| 91 | NaN | NaN | 394 | 743 | 1096 | 1490 |
| 99 | NaN | NaN | 349 | 721 | 1078 | 1479 |
| 107 | NaN | NaN | 309 | 703 | 1059 | 1459 |
| 115 | NaN | NaN | 245 | 685 | 1045 | 1444 |
| 123 | NaN | NaN | 163 | 662 | 1030 | 1431 |
| 131 | NaN | NaN | NaN | 643 | 1015 | 1419 |
| 139 | NaN | NaN | NaN | 621 | 1000 | 1406 |
| 147 | NaN | NaN | NaN | 603 | 985 | 1393 |
| 155 | NaN | NaN | NaN | 580 | 971 | 1385 |
| 163 | NaN | NaN | NaN | 562 | 955 | 1370 |
| 171 | NaN | NaN | NaN | 535 | 944 | 1360 |
| 179 | NaN | NaN | NaN | 510 | 933 | 1346 |
| 187 | NaN | NaN | NaN | 491 | 918 | 1337 |
| 195 | NaN | NaN | NaN | 469 | 904 | 1326 |
| 203 | NaN | NaN | NaN | 439 | 896 | 1319 |
| 219 | NaN | NaN | NaN | 375 | 866 | 1296 |

(continued)

| K / N | 32 | 64 | 128 | 256 | 512 | 1024 |
|---|---|---|---|---|---|---|
| 235 | NaN | NaN | NaN | 300 | 840 | 1279 |
| 251 | NaN | NaN | NaN | 163 | 818 | 1259 |
| 267 | NaN | NaN | NaN | NaN | 797 | 1243 |
| 283 | NaN | NaN | NaN | NaN | 770 | 1225 |
| 299 | NaN | NaN | NaN | NaN | 743 | 1208 |

Example Six:

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [780, 656, 552, 464, 390, 328, 276, 232, 195, 164]$, and n = 10; N is a positive integer power of 2, including, but not limited to, one of: 32, 64, 128, 256, 512, or 1024; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 7 provides a specific example of the reliability threshold table. In another example, the reliability threshold table includes at least one row or at least one column in Table 7.

Table 7 Reliability threshold table when $\beta = [780, 656, 552, 464, 390, 328, 276, 232, 195, 164]$

| K / N | 32 | 64 | 128 | 256 | 512 | 1024 |
|---|---|---|---|---|---|---|
| 25 | 396 | 898 | 1390 | 1966 | 2622 | 3402 |
| 35 | NaN | 755 | 1294 | 1861 | 2533 | 3313 |
| 43 | NaN | 635 | 1213 | 1802 | 2465 | 3251 |
| 51 | NaN | 508 | 1145 | 1740 | 2406 | 3201 |
| 59 | NaN | 328 | 1068 | 1688 | 2366 | 3149 |
| 67 | NaN | NaN | 1000 | 1629 | 2315 | 3102 |
| 75 | NaN | NaN | 935 | 1583 | 2273 | 3062 |
| 83 | NaN | NaN | 861 | 1541 | 2234 | 3025 |
| 91 | NaN | NaN | 792 | 1495 | 2202 | 2993 |
| 99 | NaN | NaN | 703 | 1450 | 2164 | 2969 |
| 107 | NaN | NaN | 622 | 1413 | 2127 | 2931 |
| 115 | NaN | NaN | 492 | 1375 | 2099 | 2900 |
| 123 | NaN | NaN | 328 | 1331 | 2069 | 2873 |
| 131 | NaN | NaN | NaN | 1292 | 2039 | 2850 |
| 139 | NaN | NaN | NaN | 1248 | 2009 | 2824 |
| 147 | NaN | NaN | NaN | 1211 | 1979 | 2798 |
| 155 | NaN | NaN | NaN | 1167 | 1950 | 2780 |
| 163 | NaN | NaN | NaN | 1130 | 1919 | 2753 |
| 171 | NaN | NaN | NaN | 1075 | 1895 | 2730 |
| 179 | NaN | NaN | NaN | 1025 | 1874 | 2705 |

(continued)

| K N | 32 | 64 | 128 | 256 | 512 | 1024 |
|---|---|---|---|---|---|---|
| 187 | NaN | NaN | NaN | 987 | 1845 | 2685 |
| 195 | NaN | NaN | NaN | 942 | 1817 | 2663 |
| 203 | NaN | NaN | NaN | 882 | 1799 | 2647 |
| 219 | NaN | NaN | NaN | 755 | 1741 | 2603 |
| 235 | NaN | NaN | NaN | 604 | 1690 | 2570 |
| 251 | NaN | NaN | NaN | 328 | 1645 | 2529 |
| 267 | NaN | NaN | NaN | NaN | 1601 | 2496 |
| 283 | NaN | NaN | NaN | NaN | 1547 | 2460 |
| 299 | NaN | NaN | NaN | NaN | 1495 | 2427 |

Example Seven:

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence β.

For example, the quantization weight value sequence is $\beta = [\beta_{n-1}, \beta_{n-2},..., \beta_0] = [51, 43, 36, 30, 25, 21, 18, 15, 13]$, and n = 9; N is a positive integer power of 2, including, but not limited to, one of: 32, 64, 128, 256, or 512; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 8 provides a specific example of the reliability threshold table. In another example, the reliability threshold table includes at least one row or at least one column in Table 8.

Table 8 Reliability threshold table when β = [51, 43, 36, 30, 25, 21, 18, 15, 13]

| K N | 32 | 64 | 128 | 256 | 512 |
|---|---|---|---|---|---|
| 25 | 31 | 69 | 107 | 152 | 203 |
| 35 | NaN | 58 | 100 | 144 | 196 |
| 43 | NaN | 49 | 94 | 140 | 191 |
| 51 | NaN | 39 | 88 | 134 | 186 |
| 59 | NaN | 25 | 82 | 130 | 183 |
| 67 | NaN | NaN | 77 | 126 | 179 |
| 75 | NaN | NaN | 72 | 122 | 176 |
| 83 | NaN | NaN | 67 | 119 | 173 |
| 91 | NaN | NaN | 61 | 115 | 170 |
| 99 | NaN | NaN | 54 | 112 | 168 |
| 107 | NaN | NaN | 48 | 109 | 165 |
| 115 | NaN | NaN | 38 | 106 | 163 |
| 123 | NaN | NaN | 25 | 103 | 160 |
| 131 | NaN | NaN | NaN | 100 | 158 |
| 139 | NaN | NaN | NaN | 97 | 155 |
| 147 | NaN | NaN | NaN | 94 | 153 |

(continued)

| K / N | 32 | 64 | 128 | 256 | 512 |
|---|---|---|---|---|---|
| 155 | NaN | NaN | NaN | 90 | 151 |
| 163 | NaN | NaN | NaN | 87 | 148 |
| 171 | NaN | NaN | NaN | 83 | 147 |
| 179 | NaN | NaN | NaN | 79 | 145 |
| 187 | NaN | NaN | NaN | 76 | 143 |
| 195 | NaN | NaN | NaN | 73 | 140 |
| 203 | NaN | NaN | NaN | 68 | 139 |
| 219 | NaN | NaN | NaN | 58 | 135 |
| 235 | NaN | NaN | NaN | 46 | 131 |
| 251 | NaN | NaN | NaN | 25 | 127 |
| 267 | NaN | NaN | NaN | NaN | 124 |
| 283 | NaN | NaN | NaN | NaN | 120 |
| 299 | NaN | NaN | NaN | NaN | 115 |

Example Eight:

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [101, 85, 71, 60, 50, 42, 35, 30, 25]$, and n = 9; N is a positive integer power of 2, including, but not limited to, one of: 32, 64, 128, 256, or 512; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 9 provides a specific example of the reliability threshold table. In another example, the reliability threshold table includes at least one row or at least one column in Table 9.

Table 9 Reliability threshold table when $\beta = [101, 85, 71, 60\ 50\ 42, 35,30\ 25]$

| K / N | 32 | 64 | 128 | 256 | 512 |
|---|---|---|---|---|---|
| 25 | 60 | 137 | 212 | 301 | 402 |
| 35 | NaN | 115 | 198 | 285 | 389 |
| 43 | NaN | 97 | 186 | 276 | 378 |
| 51 | NaN | 77 | 175 | 266 | 368 |
| 59 | NaN | 50 | 163 | 258 | 363 |
| 67 | NaN | NaN | 152 | 250 | 354 |
| 75 | NaN | NaN | 143 | 242 | 348 |
| 83 | NaN | NaN | 132 | 236 | 343 |
| 91 | NaN | NaN | 121 | 228 | 338 |
| 99 | NaN | NaN | 107 | 222 | 332 |
| 107 | NaN | NaN | 95 | 216 | 326 |
| 115 | NaN | NaN | 75 | 211 | 322 |

(continued)

| K\nN | 32 | 64 | 128 | 256 | 512 |
|---|---|---|---|---|---|
| 123 | NaN | NaN | 50 | 203 | 317 |
| 131 | NaN | NaN | NaN | 198 | 313 |
| 139 | NaN | NaN | NaN | 191 | 308 |
| 147 | NaN | NaN | NaN | 186 | 303 |
| 155 | NaN | NaN | NaN | 178 | 299 |
| 163 | NaN | NaN | NaN | 173 | 294 |
| 171 | NaN | NaN | NaN | 165 | 291 |
| 179 | NaN | NaN | NaN | 157 | 287 |
| 187 | NaN | NaN | NaN | 151 | 283 |
| 195 | NaN | NaN | NaN | 145 | 278 |
| 203 | NaN | NaN | NaN | 135 | 276 |
| 219 | NaN | NaN | NaN | 115 | 267 |
| 235 | NaN | NaN | NaN | 92 | 258 |
| 251 | NaN | NaN | NaN | 50 | 252 |
| 267 | NaN | NaN | NaN | NaN | 246 |
| 283 | NaN | NaN | NaN | NaN | 237 |
| 299 | NaN | NaN | NaN | NaN | 228 |

Example Nine:

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [206, 173, 145, 122, 102, 86, 73, 61, 51]$, and n = 9; N is a positive integer power of 2, including, but not limited to, one of: 32, 64, 128, 256, or 512; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 10 provides a specific example of the reliability threshold table. In another example, the reliability threshold table includes at least one row or at least one column in Table 10.

Table 10 Reliability threshold table when $\beta = [206, 173, 145, 122, 102, 86, 73, 61, 51]$

| K\nN | 32 | 64 | 128 | 256 | 512 |
|---|---|---|---|---|---|
| 25 | 124 | 281 | 434 | 615 | 821 |
| 35 | NaN | 236 | 404 | 582 | 793 |
| 43 | NaN | 198 | 379 | 564 | 772 |
| 51 | NaN | 159 | 358 | 544 | 752 |
| 59 | NaN | 102 | 333 | 528 | 740 |
| 67 | NaN | NaN | 312 | 509 | 724 |
| 75 | NaN | NaN | 292 | 495 | 711 |
| 83 | NaN | NaN | 269 | 481 | 699 |

(continued)

| K / N | 32 | 64 | 128 | 256 | 512 |
|---|---|---|---|---|---|
| 91 | NaN | NaN | 247 | 467 | 689 |
| 99 | NaN | NaN | 220 | 454 | 677 |
| 107 | NaN | NaN | 195 | 442 | 666 |
| 115 | NaN | NaN | 153 | 430 | 658 |
| 123 | NaN | NaN | 102 | 416 | 648 |
| 131 | NaN | NaN | NaN | 404 | 638 |
| 139 | NaN | NaN | NaN | 391 | 628 |
| 147 | NaN | NaN | NaN | 379 | 618 |
| 155 | NaN | NaN | NaN | 365 | 610 |
| 163 | NaN | NaN | NaN | 353 | 600 |
| 171 | NaN | NaN | NaN | 336 | 593 |
| 179 | NaN | NaN | NaN | 320 | 587 |
| 187 | NaN | NaN | NaN | 308 | 577 |
| 195 | NaN | NaN | NaN | 295 | 567 |
| 203 | NaN | NaN | NaN | 275 | 564 |
| 219 | NaN | NaN | NaN | 236 | 544 |
| 235 | NaN | NaN | NaN | 188 | 528 |
| 251 | NaN | NaN | NaN | 102 | 515 |
| 267 | NaN | NaN | NaN | NaN | 501 |
| 283 | NaN | NaN | NaN | NaN | 485 |
| 299 | NaN | NaN | NaN | NaN | 467 |

Example Ten:

A reliability threshold is obtained from a preset mapping relationship according to an index value. In this example, the index value is determined according to a value of a number K of information bits and a value of a number N of polarized subchannels, and a mapping relationship between the number K of information bits, the number N of polarized subchannels, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0] = [480, 404, 340, 286, 240, 202, 170, 143, 120]$, and $n = 9$; N is a positive integer power of 2, including, but not limited to, one of: 32, 64, 128, 256, or 512; and K is a positive integer, including, but not limited to, one of: 25, 35, 43, 51, 59, 67, 75, 83, 91, 99, 107, 115, 123, 131, 139, 147, 155, 163, 171, 179, 187, 195, 203, 219, 235, 251, 267, 283, or 299. Table 11 provides a specific example of the reliability threshold table. In another example, the reliability threshold table includes at least one row or at least one column in Table 11.

Table 11 Reliability threshold table when B = [480, 404, 340, 286, 240, 202, 170, 143, 120]

| K / N | 32 | 64 | 128 | 256 | 512 |
|---|---|---|---|---|---|
| 25 | 290 | 658 | 1018 | 1440 | 1920 |
| 35 | NaN | 553 | 948 | 1363 | 1855 |
| 43 | NaN | 465 | 889 | 1320 | 1805 |
| 51 | NaN | 372 | 839 | 1274 | 1762 |

(continued)

| K N | 32 | 64 | 128 | 256 | 512 |
|---|---|---|---|---|---|
| 59 | NaN | 240 | 782 | 1236 | 1732 |
| 67 | NaN | NaN | 732 | 1193 | 1695 |
| 75 | NaN | NaN | 685 | 1159 | 1665 |
| 83 | NaN | NaN | 631 | 1129 | 1636 |
| 91 | NaN | NaN | 580 | 1095 | 1612 |
| 99 | NaN | NaN | 515 | 1062 | 1584 |
| 107 | NaN | NaN | 456 | 1035 | 1557 |
| 115 | NaN | NaN | 360 | 1007 | 1537 |
| 123 | NaN | NaN | 240 | 975 | 1515 |
| 131 | NaN | NaN | NaN | 946 | 1493 |
| 139 | NaN | NaN | NaN | 914 | 1471 |
| 147 | NaN | NaN | NaN | 887 | 1449 |
| 155 | NaN | NaN | NaN | 855 | 1428 |
| 163 | NaN | NaN | NaN | 828 | 1405 |
| 171 | NaN | NaN | NaN | 787 | 1387 |
| 179 | NaN | NaN | NaN | 751 | 1372 |
| 187 | NaN | NaN | NaN | 723 | 1351 |
| 195 | NaN | NaN | NaN | 690 | 1331 |
| 203 | NaN | NaN | NaN | 646 | 1317 |
| 219 | NaN | NaN | NaN | 553 | 1275 |
| 235 | NaN | NaN | NaN | 442 | 1238 |
| 251 | NaN | NaN | NaN | 240 | 1205 |
| 267 | NaN | NaN | NaN | NaN | 1173 |
| 283 | NaN | NaN | NaN | NaN | 1133 |
| 299 | NaN | NaN | NaN | NaN | 1095 |

Example Eleven:

A reliability threshold is obtained from a preset mapping relationship according to an index value. In this example, the index value is determined according to a value of a number K of information bits and a value of a code rate R, and a mapping relationship between the number K of information bits, the code rate R, and the reliability threshold is recorded through a reliability threshold table, and elements in the reliability threshold table are determined based on the quantization weight value sequence $\beta$.

For example, the quantization weight value sequence is $\beta = [\beta_{n-1}, \beta_{n-2}, ..., \beta_0]$ = [97, 165, 139, 116, 98, 82, 68, 58, 49, 41], and n = 10; R is a real number greater than 0 and less than 1, including, but not limited to, one of: 25/32, 25/64, 25/128, 25/256, 25/512, 25/1024, 35/64, 35/128, 35/256, 35/512, 35/1024, 43/64, 43/128, 43/256, 43/512, 43/1024, 51/64, 51/128, 51/256, 51/512, 51/1024, 59/64, 59/128, 59/256, 59/512, or 59/1024; and K is a positive integer, including, but not limited to, one of: 25, 35, 43, 51, or 59. Table 12 provides a specific example of the reliability threshold table. In another example, the reliability threshold table includes at least one row or at least one column in Table 12.

Table 12 Reliability threshold table indexed by K and R when β = [197, 165, 139, 116, 98, 82, 68, 58, 49, 41]

| K=25 | R | 25/32 | 25/64 | 25/128 | 25/256 | 25/512 | 25/1024 |
|---|---|---|---|---|---|---|---|
| | $W_{K,R}$ | 99 | 224 | 347 | 493 | 658 | 855 |
| K=35 | R | 35/32 | 35/64 | 35/128 | 35/256 | 35/512 | 35/1024 |
| | $W_{K,R}$ | NaN | 189 | 323 | 467 | 635 | 832 |
| K=43 | R | 43/32 | 43/64 | 43/128 | 43/256 | 43/512 | 43/1024 |
| | $W_{K,R}$ | NaN | 158 | 304 | 452 | 618 | 816 |
| K=51 | R | 51/32 | 51/64 | 51/128 | 51/256 | 51/512 | 51/1024 |
| | $W_{K,R}$ | NaN | 126 | 287 | 436 | 602 | 805 |
| K=59 | R | 59/32 | 59/64 | 59/128 | 59/256 | 59/512 | 59/1024 |
| | 59 | NaN | 82 | 266 | 422 | 593 | 790 |

Example Twelve:

A reliability threshold is obtained from a preset mapping relationship according to an index value. In this example, the index value is determined according to a value of a number K of information bits and a value of a code rate R, and a mapping relationship between the number K of information bits, the code rate R, and the reliability threshold is recorded through a reliability threshold table, and elements in the reliability threshold table are determined based on the quantization weight value sequence β.

For example, the quantization weight value sequence is β = [$\beta_{n-1}$, $\beta_{n-2}$, ..., $\beta_0$] = [480, 404, 340, 286, 240, 202, 170, 143, 120], and n = 9; R is a real number greater than 0 and less than 1, including, but not limited to, one of: 25/32, 25/64, 25/128, 25/256, 25/512, 35/64, 35/128, 35/256, 35/512, 43/64, 43/128, 43/256, 43/512, 51/64, 51/128, 51/256, 51/512, 59/64, 59/128, 59/256, or 59/512; and K is a positive integer, including, but not limited to, one of: 25, 35, 43, 51, or 59. Table 13 provides a specific example of the reliability threshold table. In another example, the reliability threshold table includes at least one row or at least one column in Table 13.

Table 13 Reliability threshold table indexed by K and R when β = [480, 404, 340, 286, 240, 202, 170, 143, 120]

| K=25 | R | 25/32 | 25/64 | 25/128 | 25/256 | 25/512 |
|---|---|---|---|---|---|---|
| | $W_{K,R}$ | 290 | 658 | 1018 | 1440 | 1920 |
| K=35 | R | 35/32 | 35/64 | 35/128 | 35/256 | 35/512 |
| | $W_{K,R}$ | NaN | 553 | 948 | 1363 | 1855 |
| K=43 | R | 43/32 | 43/64 | 43/128 | 43/256 | 43/512 |
| | $W_{K,R}$ | NaN | 465 | 889 | 1320 | 1805 |
| K=51 | R | 51/32 | 51/64 | 51/128 | 51/256 | 51/512 |
| | $W_{K,R}$ | NaN | 372 | 839 | 1274 | 1762 |
| K=59 | R | 59/32 | 59/64 | 59/128 | 59/256 | 59/512 |
| | 59 | NaN | 240 | 782 | 1236 | 1732 |

Example Thirteen:

In a possible embodiment, a reliability value of a subchannel is calculated based on a quantization weight value sequence, and a reliability threshold of an $i^{th}$ polarized subchannel is calculated according to the following formula:

$$w_i' = \sum_{j=0}^{n-1} B_j \cdot \beta_j \quad \text{(Formula 3)}$$

where n = $\log_2 N$ represents a number of bits required to express the integer N in a binary form; i is an integer greater than or equal to 0 and less than N, i is expressed in binary form, and $i = B_{n-1}B_{n-2}...B_2B_1B_0$; $B_j$ represents a $j^{th}$ bit corresponding to the integer i in the binary form and has a value of bit 0 or bit 1, where $j = \{0, 1, 2, ..., n-2, n-1\}$; and $\beta_j$ is a quantization weight value corresponding to the $j^{th}$ bit $B_j$ in the binary expression of i, and has a value which is an integer greater than 0.

It can be understood that the quantization weight value sequence $\beta$ includes one of: $\beta = [\beta_{n-1}, \beta_{n-2}, ..., \beta_0]$ is a sequence of positive integers in descending order; or $\beta = [\beta_0, \beta_1, ..., \beta_{n-1}]$ is a sequence of positive integers in ascending order.

It can be understood that the quantization weight value sequence $\beta$ satisfies, but not limited to, one of the following conditions: the quantization weight value sequence $\beta$ includes N quantization weight values, $\beta_j$ is the quantization weight value corresponding to $B_j$, $B_j$ represents the $j^{th}$ bit in the integer i in binary form, $i = B_{n-1}B_{n-2}...B_2B_1B_0$, the $0^{th}$ bit $B_0$ is the lowest bit, the $(n-1)^{th}$ bit $B_{n-1}$ is the highest bit, $n = \log_2 N$, N is the number of polarized subchannels, and $j \in \{0, 1, 2, ..., n-2, n-1\}$.

It can be understood that the quantization weight value sequence $\beta = [\beta_{n-1}, \beta_{n-2}, ..., \beta_0]$ satisfies $\beta_{n-1}+\beta_{n-2}+...+\beta_0 < M$, where M is a positive integer power of 2. A value of M includes at least one of: 256, 512, 1024, 2048, or 4096.

It can be understood that the quantization weight value sequence $\beta = [\beta_{n-1}, \beta_{n-2}, ..., \beta_0]$ is determined in, for example, but not limited to, at least one of the following manners: the quantization weight value sequence is preset, the quantization weight value sequence is determined according to a sum of elements $\beta_{n-1}+\beta_{n-2}+...+\beta_0 < M$, or the quantization weight value sequence is determined according to a constraint condition that a number of differences between a quantized PW sequence obtained by the quantization weight value sequence and a PW sequence is not greater than a second value D. M is a positive integer power of 2, and a value of M includes, but not limited to, one of: 256, 512, 1024, 2048, or 4096. $\beta_j$ is a positive integer, $j \in \{0, 1, 2, ..., n-2, n-1\}$, and $n = \log_2 N$. D is an integer greater than or equal to 0 and less than N.

It can be understood that when the value of D is small, the obtained number of differences between the quantized PW sequence and the PW sequence is small, but a larger M is required to satisfy the storage of the quantized PW sequence, i.e., more storage space is required to store the reliability threshold; and when the value of D is large, the obtained number of differences between the quantized PW sequence and the PW sequence is large, and the storage of the quantized PW sequence does not require a large M, i.e., only a small storage space is required to store the reliability threshold. Different application scenarios can be met by adjusting the value of D.

In an example, M = 256, N = 512, n = 9, D = 254, and the quantization weight value sequence is $\beta = [\beta_{n-1}, \beta_{n-2}, ..., \beta_0] = [51, 43, 36, 30, 25, 21, 18, 15, 13]$, where the quantization weight value sequence $\beta$ satisfies: the sum of elements in the sequence is $\beta_{n-1}+\beta_{n-2}+...+\beta_0 = 252 < M$. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 254 and is not greater than D, i.e., there are 254 positions at which $PW_{quan}(i) \neq PW(i)$, i = 0, 1, ..., N-1.

In another example, M = 512, N = 512, n = 9, D = 76, and the quantization weight value sequence is $\beta = [\beta_{n-1}, \beta_{n-2}, ..., \beta_0] = [101, 85, 71, 60, 50, 42, 35, 30, 25]$, where the quantization weight value sequence $\beta$ satisfies the following feature: the sum of elements in the sequence is $\beta_{n-1}+\beta_{n-2}+...+\beta_0 = 499 < M$. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 76 and is not greater than D, i.e., there are 76 positions at which $PW_{quan}(i) \neq PW$, i = 0, 1, ..., N-1.

In still another example, M = 1024, N = 512, n = 9, D = 6, and the quantization weight value sequence is $\beta = [\beta_{n-1}, \beta_{n-2}, ..., \beta_0] = [206, 173, 145, 122, 102, 86, 73, 61, 51]$, where the quantization weight value sequence $\beta$ satisfies the following feature: the sum of elements in the sequence is $\beta_{n-1}+\beta_{n-2}+...+\beta_0 = 1019 < M$. An $i^{th}$ subchannel reliability value $w'_i$ is calculated according to the quantization weight value sequence $\beta$, i = 0, 1, ..., N-1, the N subchannel reliability values are sorted in descending order, and PW' = $[PW_{N-1}, PW_{N-2}, ..., PW_0]$ is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan} = [PW_0, PW_1, ..., PW_{N-1}]$. The quantized PW sequence ($PW_{quan}$) obtained according to the parameters is compared with the PW sequence (PW), where the number of differences between the quantized PW sequence and the PW sequence is 6 and is not greater than D, i.e., there are 6 positions at which $PW_{quan}(i) \neq PW(i)$, i = 0, 1, ..., N-1.

In yet another example, M = 4096, N = 512, n = 9, D = 0, and the quantization weight value sequence is $\beta$ = [$\beta_{n-1}$, $\beta_{n-2}$, ..., $\beta_0$] = [480, 404, 340, 286, 240, 202, 170, 143, 120], where the quantization weight value sequence $\beta$ satisfies the following feature: the sum of elements in the sequence is $\beta_{n-1}+\beta_{n-2}+...+\beta_0$ = 2385 < M. An $i^{th}$ subchannel reliability value $w'_i$ is calculated according to the quantization weight value sequence $\beta$, i = 0, 1, ..., N-1, the N subchannel reliability values are sorted in descending order, and PW' = [$PW_{N-1}$, $PW_{N-2}$, ..., $PW_0$] is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan}$ = [$PW_0$, $PW_1$, ..., $PW_{N-1}$]. The quantized PW sequence ($PW_{quan}$) obtained according to the parameters is compared with the PW sequence (PW), where the number of differences between the quantized PW sequence and the PW sequence is 0 and is not greater than D, i.e., there are 0 positions at which $PW_{quan}(i) \neq PW(i)$, i = 0, 1, ..., N-1.

In yet another example, M = 512, N = 1024, n = 10, D = 466, and the quantization weight value sequence is $\beta$ = [$\beta_{n-1}$, $\beta_{n-2}$, ..., $\beta_0$] = [96, 81, 68, 57, 48, 40, 34, 28, 24, 20], where the quantization weight value sequence $\beta$ satisfies the following feature: the sum of elements in the sequence is $\beta_{n-1}+\beta_{n-2}+...+\beta_0$ = 496 < M. An $i^{th}$ subchannel reliability value $w'_i$ is calculated according to the quantization weight value sequence $\beta$, i = 0, 1, ..., N-1, the N subchannel reliability values are sorted in descending order, and PW' = [$PW_{N-1}$, $PW_{N-2}$, ..., $PW_0$] is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan}$ = [$PW_0$, $PW_1$, ..., $PW_{N-1}$]. The quantized PW sequence ($PW_{quan}$) obtained according to the parameters is compared with the PW sequence (PW), where the number of differences between the quantized PW sequence and the PW sequence is 466 and is not greater than D, i.e., there are 466 positions at which $PW_{quan}(i) \neq PW(i)$, i = 0, 1, ..., N-1.

In yet another example, M = 1024, N = 1024, n = 10, D = 70, and the quantization weight value sequence is $\beta$ = [$\beta_{n-1}$, $\beta_{n-2}$, ..., $\beta_0$] = [197, 165, 139, 116, 98, 82, 68, 58, 49, 41], where the quantization weight value sequence $\beta$ satisfies the following feature: the sum of elements in the sequence is $\beta_{n-1}+\beta_{n-2}+...+\beta_0$ = 1013 < M. An $i^{th}$ subchannel reliability value $w'_i$ is calculated according to the quantization weight value sequence $\beta$, i = 0, 1, ..., N-1, the N subchannel reliability values are sorted in descending order, and PW' = [$PW_{N-1}$, $PW_{N-2}$, ..., $PW_0$] is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan}$ = [$PW_0$, $PW_1$, ..., $PW_{N-1}$]. The quantized PW sequence ($PW_{quan}$) obtained according to the parameters is compared with the PW sequence (PW), where the number of differences between the quantized PW sequence and the PW sequence is 70 and is not greater than D, i.e., there are 70 positions at which $PW_{quan}(i) \neq PW(i)$, i = 0, 1, ..., N-1.

In yet another example, M = 2048, N = 1024, n = 10, D = 24, and the quantization weight value sequence is $\beta$ = [$\beta_{n-1}$, $\beta_{n-2}$, ..., $\beta_0$] = [389, 327, 275, 231, 194, 163, 137, 115, 97, 82], where the quantization weight value sequence $\beta$ satisfies the following feature: the sum of elements in the sequence is $\beta_{n-1}+\beta_{n-2}+...+\beta_0$ = 2010 < M. An $i^{th}$ subchannel reliability value $w'_i$ is calculated according to the quantization weight value sequence $\beta$, i = 0, 1, ..., N-1, the N subchannel reliability values are sorted in descending order, and PW' = [$PW_{N-1}$, $PW_{N-2}$, ..., $PW_0$] is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan}$ = [$PW_0$, $PW_1$, ..., $PW_{N-1}$]. The quantized PW sequence ($PW_{quan}$) obtained according to the parameters is compared with the PW sequence (PW), where the number of differences between the quantized PW sequence and the PW sequence is 24 and is not greater than D, i.e., there are 24 positions at which $PW_{quan}(i) \neq PW(i)$, i = 0, 1, ..., N-1.

In yet another example, M = 4096, N = 1024, n = 10, D = 0, and the quantization weight value sequence is $\beta$ = [$\beta_{n-1}$, $\beta_{n-2}$, ..., $\beta_0$] = [780, 656, 552, 464, 390, 328, 276, 232, 195, 164], where the quantization weight value sequence $\beta$ satisfies the following feature: the sum of elements in the sequence is $\beta_{n-1}+\beta_{n-2}+...+\beta_0$ = 4037 < M. An $i^{th}$ subchannel reliability value $w'_i$ is calculated according to the quantization weight value sequence $\beta$, i = 0, 1, ..., N-1, the N subchannel reliability values are sorted in descending order, and PW' = [$PW_{N-1}$, $PW_{N-2}$, ..., $PW_0$] is obtained according to index values after the sorting, where $PW_{N-1}$ represents a subchannel index number corresponding to a highest reliability value, $PW_0$ represents a subchannel index number corresponding to a lowest reliability value, and the PW' sequence is reversed to obtain a quantized PW sequence: $PW_{quan}$ = [$PW_0$, $PW_1$, ..., $PW_{N-1}$]. The quantized PW sequence ($PW_{quan}$) obtained according to the parameters is compared with the PW sequence (PW), where the number of differences between the quantized PW sequence and the PW sequence is 0 and is not greater than D, i.e., there are 0 positions at which $PW_{quan}(i) \neq PW(i)$, i = 0, 1, ..., N-1.

Example Fourteen:

It can be understood that the information and frozen bit indication corresponding to the polarized subchannel is determined according to the subchannel reliability value and the reliability threshold. A process of determining an information and frozen bit indication corresponding to an $i^{th}$ polarized subchannel includes: when a reliability value $w'_i$ of the $i^{th}$ subchannel is greater than or equal to a reliability threshold $w_{th}$, determining that the $i^{th}$ subchannel carries information bits; and when the reliability value $w'_i$ of the $i^{th}$ subchannel is less than the reliability threshold $w_{th}$, determining that the $i^{th}$ subchannel carries frozen bits.

For example, the information and frozen bit indication corresponding to the $i^{th}$ subchannel is represented by a flag bit F, and if $w'_i \geq w_{th}$, $F = b_1$, indicating that the $i^{th}$ subchannel carries information bits; otherwise, $F = b_0$, indicating that the $i^{th}$ subchannel carries frozen bits. $b_0$ and $b_1$ are two binary bit values which are not equal. In a specific example, if $w'_i \geq w_{th}$, $F = 1$, indicating that the $i^{th}$ subchannel carries information bits; otherwise, $F = 0$, indicating that the $i^{th}$ subchannel carries frozen bits.

Example Fifteen

It can be understood that a value of a bit corresponding to a polarized subchannel in an information and frozen bit sequence is determined according to an information and frozen bit indication, and a finally obtained information and frozen bit sequence and the information bit sequence satisfy the following mapping relationship $u_{f1(i)} = a_{f2(j)}$, where f1 is a function of j, and is determined according to, for example, but not limited to, f2(j), an information and frozen bit indication, and an information index number, and $f1(j) \in \{0, 1, ..., N-1\}$; f2 is a function of j, including, but not limited to, f(j)=j and f(j)=K-j; $f2(j) \in \{0, 1, ..., K-1\}$; and j = 0, 1, ..., K-1. Based on the information and frozen bit indication corresponding to the subchannel, the information and frozen bit sequence is updated using the information index number. An initial value of the information index number points to the first information bit or the last information bit.

For example, when the information bits in the information bit sequence $a = [a_0, a_1, ..., a_{k-1}]$ are sequentially set at the first K bits of the information and frozen bit sequence, an initial information and frozen bit sequence $u = [u_0, u_1, ..., u_{n-1}] = [a_0, a_1, ..., a_{K-1}, 0, ...,0]$ is obtained. The initial value of the information index number is set to k = K-1, pointing to the last information bit $a_{K-1}$ in u. An initial value of the subchannel index number is set to i = N-1, pointing to the last bit in u. FIG. 4 shows a logic code for updating the information and frozen bit sequence based on the information index number k and the information and frozen bit indication F, including, but not limited to, the following operations: if $k \geq 0$ and F = 1, then $u_i = u_k$, k = k - 1, and i = i - 1; otherwise, $u_i = 0$, and i = i - 1. The above operations are repeated N times, and when i = 0, the update of the information and frozen bit sequence is completed, thus obtaining a final information and frozen bit sequence. N is the number of polarized subchannels and has a value which is a positive integer power of 2. K is the number of information bits and has a value which is a positive integer, and K < N. F = 1 indicates that the $i^{th}$ subchannel carries information bits. F = 0 indicates that the $i^{th}$ subchannel carries frozen bits.

Example Sixteen:

When information bits in an information bit sequence $a = [a_0, a_1, ..., a_{k-1}]$ are sequentially set at the last K bits of an information and frozen bit sequence, an initial information and frozen bit sequence $u = [u_0, u_1, ..., u_{n-1}] = [0, ..., 0, a_0, a_1, ..., a_{k-1}]$ is obtained. An initial value of an information index number is set to k = N-K, pointing to the first information bit $a_0$ in u. An initial value of a subchannel index number is set to i = 0, pointing to the first bit in u. FIG. 5 shows a logic code for updating the information and frozen bit sequence based on the information index number k and the information and frozen bit indication F, including, but not limited to, the following operations: if $k \leq N-1$ and F = 1, then $u_i = u_k$, k = k + 1, and i = i + 1; otherwise, $u_i = 0$, and i = i + 1. The above operations are repeated N times, and when i = N-1, the update of the information and frozen bit sequence is completed, thus obtaining a final information and frozen bit sequence. N is the number of polarized subchannels and has a value which is a positive integer power of 2. K is the number of information bits and has a value which is a positive integer, and K < N. F = 1 indicates that the $i^{th}$ subchannel carries information bits. F = 0 indicates that the $i^{th}$ subchannel carries frozen bits.

Example Seventeen:

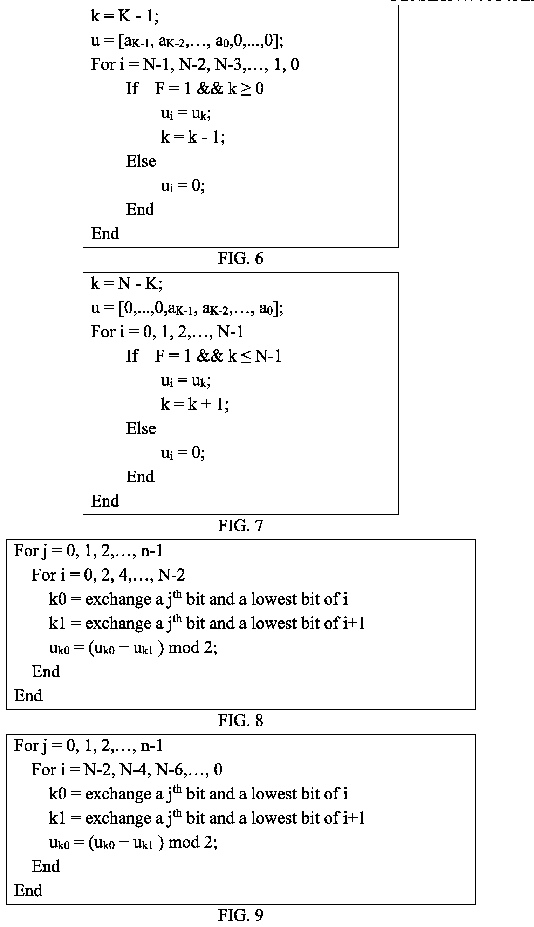

When information bits in an information bit sequence $a = [a_0, a_1, ..., a_{K-1}]$ are set in reverse order at the first K bits of an information and frozen bit sequence, an initial information and frozen bit sequence $u = [u_0, u_1, ..., u_{n-1}] = [a_{k-1}, a_{K-2}, ..., a_0, 0, ..., 0]$ is obtained. An initial value of an information index number is set to k = K-1, pointing to the first information bit $a_0$ in u. An initial value of a subchannel index number is set to i = N-1, pointing to the last bit in u. FIG. 6 shows a logic code for updating the information and frozen bit sequence based on the information index number k and the information and frozen bit indication F, including, but not limited to, the following operations: if $k \geq 0$ and F = 1, then $u_i = u_k$, k = k - 1, and i = i - 1;

otherwise, $u_i = 0$, and i = i - 1. The above operations are repeated N times, and when i = 0, the update of the information and frozen bit sequence is completed, thus obtaining a final information and frozen bit sequence. N is the number of polarized subchannels and has a value which is a positive integer power of 2. K is the number of information bits and has a value which is a positive integer, and K < N. F = 1 indicates that the ith subchannel carries information bits. F = 0 indicates that the ith subchannel carries frozen bits.

Example Eighteen:

When information bits in an information bit sequence a = [$a_0$, $a_1$, ..., $a_{k-1}$] are set in reverse order at the last K bits of an initial information and frozen bit sequence, an initial information and frozen bit sequence u = [$u_0$, $u_1$, ..., $u_{n-1}$] = [0, ..., 0, $a_{K-1}$, $a_{K-2}$, ..., $a_0$] is obtained. An initial value of an information index number is set to k = N-K, pointing to the last information bit $a_{K-1}$ in u. An initial value of a subchannel index number is set to i = 0, pointing to the first bit in u. FIG. 7 shows a logic code for updating the information and frozen bit sequence based on the information index number k and the information and frozen bit indication F, including, but not limited to, the following operations: if k ≤ N-1 and F = 1, then $u_i = u_k$, k = k + 1, and i = i + 1; otherwise, $u_i = 0$, and i = i + 1. The above operations are repeated N times, and when i = N-1, the update of the information and frozen bit sequence is completed, thus obtaining a final information and frozen bit sequence. N is the number of polarized subchannels and has a value which is a positive integer power of 2. K is the number of information bits and has a value which is a positive integer, and K < N. F = 1 indicates that the ith subchannel carries information bits. F = 0 indicates that the ith subchannel carries frozen bits.

Example Nineteen:

An information and frozen bit sequence has a size of N bits. The N bits include information bits and frozen bits. The information and frozen bit sequence may be obtained according to, for example, but not limited to, the operations provided in any of Example Fourteen to Example Eighteen.

It can be understood that in the embodiments of the present disclosure, after an information and frozen bit sequence u = [$u_0$, $u_1$, ..., $u_{N-1}$] is obtained, the information and frozen bit sequence u = [$u_0$, $u_1$, ..., $u_{n-1}$] is serially encoded to obtain encoded data d = [$d_0$, $d_1$, ..., $d_{u-1}$]. Intermediate encoded bits of each stage are stored in storage space of the information and frozen bit sequence, bits are calculated in groups of two in each stage, and the encoding process is serially performed in an order of Stage 0, Stage 1, ..., and Stage n-1. As such, storing the intermediate encoded bits of each stage in the storage space of the information and frozen bit sequence can reduce the storage overhead.

For example, the information and frozen bit sequence is processed in ascending order of subchannel index numbers, and the specific processing process may include: processing the information and frozen bit sequence in ascending order of subchannel index numbers, calculating bits in groups of two in each stage, and storing intermediate encoded bits of each stage in the storage space of the information and frozen bit sequence, and serially performing the encoding process in the order of Stage 0, Stage 1, ..., and Stage n-1.

For example, referring to FIG. 8, a process of encoding an information and frozen bit sequence u = [$u_0$, $u_1$, ..., $u_{n-1}$] to obtain encoded data may include the following operations: processing the information and frozen bit sequence in ascending order of subchannel index numbers i = 0, 2, 4, ..., N-2; performing calculation by using two bits at positions k0 and k1 positions of the subchannel index number in each stage as a group; in each stage, storing an intermediate encoded bit ($u_{k0} + u_{k1}$) mod 2 using a k0[th] position of the information and frozen bit sequence u; and serially performing the encoding process in the order of Stage 0, Stage 1, ..., and Stage n-1 according to j = 0, 1, 2, ..., n-1, where j represents a stage index number of polar coding.

Here, u = [$u_0$, $u_1$, ..., $u_{N-1}$] is the information and frozen bit sequence outputted in S210; i represents the subchannel index number, i is expressed in binary form as i = $B_{n-1}B_{n-2}...B_{j+1}B_jB_{j-1}...B_2B_1B_0$, and B0 represents the lowest bit; and mod 2 means finding modulo to 2. k0 represents a decimal number obtained by exchanging a jth bit and the lowest bit of i, and k1 represents a decimal number obtained by exchanging a jth bit and the lowest bit of i+1. In an example, i is an even number, $B_0 = 0$, the jth bit $B_j$ and the lowest bit $B_0$ of i = $B_{n-1}B_{n-2}...B_{j+1}B_jB_{j-1}...B_2B_1B_0$ are exchanged to obtain $k_0 = B_{n-1}B_{n-2}...B_{j+1}B_0B_{j-1}...B_2B_1B_j$. In a specific example, i = 10d = 1010b, j = 3, the jth bit and the lowest bit of i are exchanged to obtain k0 = 0011b = 3d. In an example, i is an even number, the lowest bit $B_0$ in i+1 = $B_{n-1}B_{n-2}...B_{j+1}B_jB_{j-1}...B_2B_1B_0$ is equal to 1, the jth bit $B_j$ and the lowest bit $B_0$ of i+1 = $B_{n-1}B_{n-2}...B_{j+1}B_jB_{j-1}...B_2B_1B_0$ are exchanged to obtain k1 = $B_{n-1}B_{n-2}...B_{j+1}B_0B_{j-1}...B_2B_1B_j$. In a specific example, i+1 = 1011b = 11d, j = 3, the jth bit and the lowest bit of i+1 are exchanged to obtain k1 = 1011b = 11d.

Example Twenty:

For example, the information and frozen bit sequence is processed in descending order of subchannel index numbers, and the specific processing process may include: processing the information and frozen bit sequence in descending order of subchannel index numbers, calculating bits in groups of two in each stage, and storing intermediate encoded bits of each stage in the storage space of the information and frozen bit sequence, and serially performing the encoding process in the order of Stage 0, Stage 1, ..., and Stage n-1.

For example, referring to FIG. 9, a process of encoding an information and frozen bit sequence $u = [u_0, u_1, ..., u_{n-1}]$ to obtain encoded data may include the following operations: processing the information and frozen bit sequence in ascending order of subchannel index numbers i = N-2, N-4, N-6, ..., 0; performing calculation by using two bits at positions k0 and k1 positions of the subchannel index number in each stage as a group; in each stage, storing an intermediate encoded bit $(u_{k0} + u_{k1})$ mod 2 using a k0th position of the information and frozen bit sequence u; and serially performing the encoding process in the order of Stage 0, Stage 1, ..., and Stage n-1 according to j = 0, 1, 2, ..., n-1, where j represents a stage index number of polar coding.

Here, $u = [u_0, u_1, ..., u_{n-1}]$ is the information and frozen bit sequence outputted in S210; i represents the subchannel index number, i is expressed in binary form as $i = B_{n-1}B_{n-2}...B_{j+1}B_jB_{j-1}...B_2B_1B_0$, and B0 represents the lowest bit; and mod 2 means finding modulo to 2. k0 represents a decimal number obtained by exchanging a jth bit and the lowest bit of i, and k1 represents a decimal number obtained by exchanging a jth bit and the lowest bit of i+1.

Example Twenty-one:

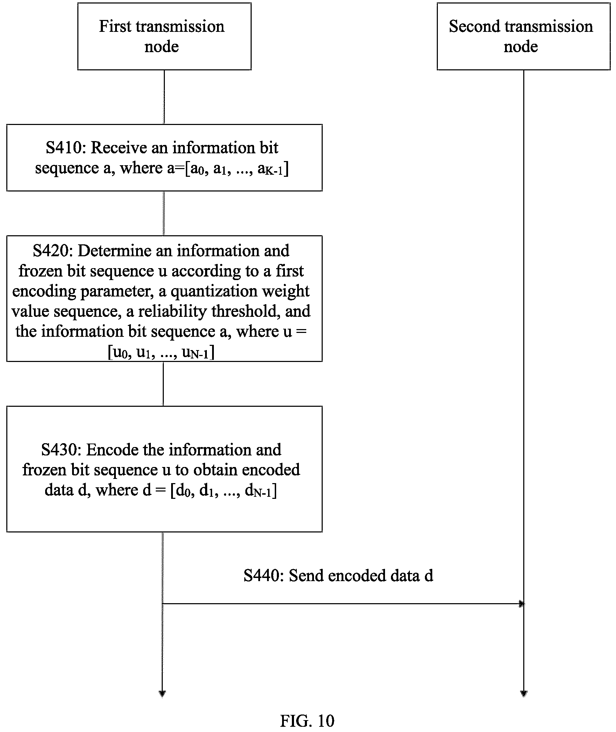

Referring to FIG. 10, this embodiment includes the following steps S410 to S440.

At S410, a first transmission node receives an information bit sequence a, where $a=[a_0, a_1, ..., a_{K-1}]$.

At S420, the first transmission node determines an information and frozen bit sequence u according to a first encoding parameter, a quantization weight value sequence, a reliability threshold, and the information bit sequence a, where $u = [u_0, u_1, ..., u_{n-1}]$.

At S430, the first transmission node encodes the information and frozen bit sequence u to obtain encoded data d, where $d = [d_0, d_1, ..., d_{N-1}]$.

At S440, the first transmission node sends the encoded data $d = [d_0, d_1, ..., d_{N-1}]$ to a second transmission node.

In accordance with a second aspect of the present disclosure, an embodiment provides a data processing method, which can be applied to the second transmission node 120 shown in FIG. 2. The data processing method includes: receiving an encoded data sequence sent by a transmit end, where the encoded data sequence is obtained by: encoding an information bit sequence according to at least one of a first encoding parameter, a quantization weight value sequence, and a reliability threshold to obtain the encoded data sequence, where the information bit sequence includes K information bits, K is an integer greater than 0, the encoded data sequence includes N pieces of encoded data, N is an integer greater than K, the quantization weight value sequence includes n quantization weight values, N represents a number of polarized subchannels, and N is less than or equal to an nth power of 2.

It can be understood that when receiving an encoded data sequence $d = [d_0, d_1, ..., d_{N-1}]$ from the transmit end, a receive end decodes the encoded data sequence $d = [d_0, d_1, ..., d_{N-1}]$ to obtain an information and frozen bit sequence $u = [u_0, u_1, ..., u_{N-1}]$; and restores the information and frozen bit sequence $u = [u_0, u_1, ..., u_{n-1}]$ to an original information bit sequence $a = [a_0, a_1, ..., a_{k-1}]$ according to at least one of a first encoding parameter, a quantization weight value sequence, and a reliability threshold.

It can be understood that the process of restoring the encoded data sequence d to the original information bit sequence a is an inverse process of converting the information bit sequence a to the encoded data sequence d, and for the specific implementation principle, reference can be made to the implementation principle of the data processing method provided by the first aspect of the embodiments of the present disclosure, so the details will not be described in the embodiments of the present disclosure again.

It can be understood that the encoded data $d = [d_0, d_1, ..., d_{N-1}]$ received by the second transmission node is obtained by the first transmission node by determining the information and frozen bit sequence u according to the first encoding parameter, the quantization weight value sequence, and the reliability threshold, and encoding the information and frozen bit sequence after acquiring the information bit sequence a.

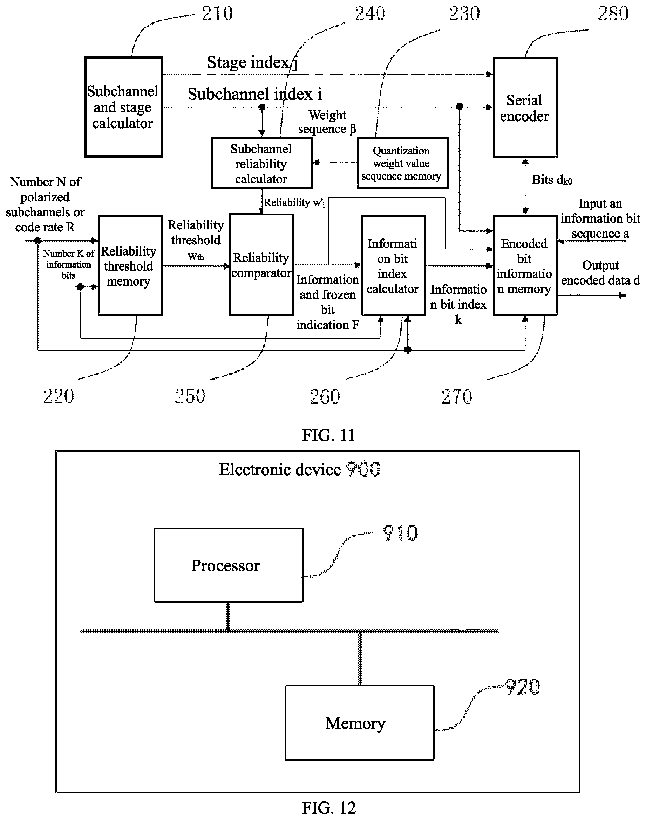

Referring to FIG. 11, in accordance with a third aspect of the present disclosure, an embodiment provides a data processing apparatus. The data processing apparatus includes at least one of:

a subchannel and stage calculator 210, configured for outputting a current subchannel index number and a current stage index number;

a reliability threshold memory 220, configured for storing a reliability threshold;

a quantization weight value sequence memory 230, configured for storing a quantization weight value sequence;

a subchannel reliability calculator 240, configured for determining a subchannel reliability value according to the quantization weight value sequence and the subchannel index number;

a reliability comparator 250, configured for comparing the subchannel reliability value with the reliability threshold, and outputting an information and frozen bit indication according to a result of the comparison;

an information bit index calculator 260, configured for outputting an information bit index according to a number of information bits, a number of polarized subchannels, and the information and frozen bit indication;

an encoded bit information memory 270, configured for receiving and storing an information bit sequence which is inputted, determining an information and frozen bit sequence according to the information bit sequence and the information and frozen bit indication, and storing the information and frozen bit sequence; and

a serial encoder 280, configured for serially encoding the information and frozen bit sequence, and outputting an encoded data sequence,

where the encoded bit information memory 270 is further configured for storing the encoded data sequence.

It can be understood that the data processing apparatus shown in FIG. 12 is a system framework for implementing the data processing method provided by the first aspect of the embodiments of the present disclosure. With the use of the framework for polar code coding, the polar code sequence does not need to be directly stored, and the position of information bits is determined online, thereby reducing the storage complexity.

In an example, an initial value of a stage index $j$ in the subchannel and stage calculator 210 is equal to -1, an initial value of a subchannel index $i$ is equal to 0, and the stage index $j$ is increased by 1 after $i$ has been counted to $N-1$ starting from 0. In an example, an initial value of a stage index $j$ in the subchannel and stage calculator 210 is equal to -1, an initial value of a subchannel index $i$ is equal to $N-1$, and the stage index $j$ is increased by 1 after $i$ has been counted down to 0 starting from $N-1$. Stage-1 represents a stage where the information and frozen bit sequence $u$ is obtained from the information bit sequence $a$. Stage 0, Stage 1, ..., Stage n-1 represent the stages where the encoded data sequence $d$ is obtained from the information and frozen bit sequence $u$.

In an example, a reliability threshold $w_{th}$ is stored in the reliability threshold memory 220, and the reliability threshold is mapped to parameters including, but not limited to, an information bit sequence size $K$, the number $N$ of polarized subchannels, and a code rate $R$.

In an example, data of a quantization weight value sequence $\beta = [\beta_{n-1}, \beta_{n-2}, ..., \beta_0]$ is stored in quantization weight value sequence memory 230. In a specific example, $\beta = [\beta_{n-1}, \beta_{n-2}, ..., \beta_0] = [197, 165, 139, 116, 98, 82, 68, 58, 49, 41]$ is stored in the quantization weight value sequence memory 230.

In an example, the subchannel reliability calculator 240 calculates a reliability value $w'_i$ of an $i^{th}$ subchannel according to the subchannel index $i$ and the quantization weight value sequence $\beta$. In a specific example, $n = 10$, $i = 5d=0000000101b$, and $\beta = [\beta_{n-1}, \beta_{n-2}, ..., \beta_0] = [197, 165, 139, 116, 98, 82, 68, 58, 49, 41]$; in this case, $w'_5 = \beta_2 + \beta_0 = 58 + 41 = 99$.

In an example, the reliability comparator 250 determines the information and frozen bit indication corresponding to the subchannel by comparing the reliability value $w'_i$ of the $i^{th}$ subchannel with the reliability threshold $w_{th}$; and the information and frozen bit indication corresponding to the $i^{th}$ subchannel is determined according to, for example, but not limited to, the following rules: when the reliability value $w'_i$ of the $i^{th}$ subchannel is greater than or equal to the reliability threshold $w_{th}$, the $i^{th}$ subchannel carries information bits, and when the reliability value $w'_i$ of the $i^{th}$ subchannel is less than the reliability threshold $w_{th}$, the $i^{th}$ subchannel carries frozen bits.

In an example, the information bit index calculator 260 calculates a position $k$ where an information bit is located. In a specific example, $u = [u_0, u_1, ..., u_{n-1}] = [0, ..., 0, a_0, a_1, ..., a_{K-1}]$, and initially $k = N-K$, i.e., the position of $a_0$; and for $i = 0$, 1, ..., N-1, if $k \leq N-1$ and $F = 1$, $u_i = u_k$, $k = k + 1$, and $i = i + 1$; otherwise, $u_i = 0$, and $i = i + 1$. $F = 1$ indicates that the $i^{th}$ subchannel carries information bits. $F = 0$ indicates that the $i^{th}$ subchannel carries frozen bits.

In an example, an information bit sequence $a$, an information and frozen bit sequence $u$, and encoded data $d$ are stored in the encoded bit information memory 270. In an example, an information bit sequence is initially inputted to the encoded bit information memory 270. In a specific example, $u = [0, ..., 0, a_0, a_1, ..., a_{k-1}]$. In an example, the stage index is $j = -1$, and after $i$ has been counted to $N-1$ starting from 0 or $i$ has been counted down to 0 starting from $N-1$, an information and frozen bit sequence $u = [u_0, u_1, ..., u_{N-1}]$ is obtained in the encoded bit information memory 270. In an example, the stage index is $j = n-1$, and encoded data $d = [d_0, d_1, ..., d_{N-1}]$ is outputted from the encoded bit information memory 270.

In an example, the serial encoder 280 encodes data of the information and frozen bit sequence in the encoded bit information memory 270 to obtain encoded data. In a specific example, $i$ is an even subchannel index number expressed in binary form as $i = B_{n-1}B_{n-2}...B_{j+1}B_jB_{j-1}...B_2B_1 0$, $k0 = B_{n-1}B_{n-2}...B_{j+1}0B_{j-1}...B_2B_1B_j$, $k1 = B_{n-1}B_{n-2}...B_{j+1}1B_{j-1}...B_2B_1B_j$, and the serial encoder 280 performs at least the following operation on the information and frozen bit sequence $u = [u_0, u_1, ..., u_{n-1}]$ in the encoded bit information memory 270: $u_{k0} = (u_{k0} + u_{k1}) \bmod 2$. The updated data $u_{k0}$ is written to the $k0^{th}$ position of the encoded bit information memory 270.

In the several embodiments provided in the present disclosure, it is to be understood that the disclosed apparatus and method may be implemented in other manners. For example, the described apparatus embodiments are only exemplary. For example, the division of the modules or units is merely a logical function division and other division manners may be used in practical implementations. For example, a plurality of units or components may be combined or integrated into another apparatus, or some features may be ignored or not performed. In addition, the shown or discussed mutual couplings or direct couplings or communication connections may be implemented through some interfaces. The indirect couplings or communication connections between the apparatus or units may be implemented in electronic, mechanical, or other forms.

It should be noted that the information exchange and execution processes between the apparatus or units are based on the same idea as the method embodiments of the present disclosure. For specific functions and technical effects of the modules, reference can be made to the descriptions in the method embodiments, and the details will not be repeated herein.

It can also be understood that although the operations in the embodiments of the present disclosure are described in a particular order in the drawings, it should not be construed as requiring that these operations be performed in a particular or serial order as shown, or that all of the illustrated operations be performed to achieve a desired result. In a particular environment, multitasking and parallel processing may be advantageous.

Referring to FIG. 12, in accordance with a fourth aspect of the present disclosure, an embodiment provides an electronic device 900, including, but not limited to,

at least one processor 910; and
at least one memory 920, configured for storing at least one program;
where the at least one program, when executed by the at least one processor 910, causes the at least one processor 910 to implement the data processing method according to any one of the above embodiments.

It should be noted that the processor 910 and the memory 920 may be connected by a bus or in other ways.

It can be understood that the processor 910 may be a Central Processing Unit (CPU). The processor may also be other general-purpose processor, a Digital Signal Processor (DSP), an Application-Specific Integrated Circuit (ASIC), a Field Programmable Gate Array (FPGA), or other programmable logic device, discrete gate or transistor logic device, discrete hardware component, or the like. The general-purpose processor may be a microprocessor or any conventional processor or the like. Alternatively, the processor 910 uses one or more integrated circuits for executing related programs to implement the technical schemes provided in the embodiments of the present disclosure.

The memory 920, as a non-transitory computer-readable storage medium, may be configured for storing a non-transitory software program and a non-transitory computer-executable program, for example, the data processing method executed by an electronic device according to any one of the embodiments of the present disclosure. The processor 910 runs the non-transitory software program and instruction stored in the memory 920, to implement the data processing method.

The memory 920 may include a program storage area and a data storage area. The program storage area may store an operating system, and an application required by at least one function. The data storage area may store data and the like required for executing the data processing method. In addition, the memory 920 may include a high-speed random access memory, and may also include a non-transitory memory, e.g., at least one magnetic disk storage device, flash memory device, or other non-transitory solid-state storage device. In some implementations, the memory 920 optionally includes memories located remotely from the processor 910, and the remote memories may be connected to the processor 910 via a network. Examples of the network include, but not limited to, the Internet, an intranet, a local area network, a mobile communication network, and combinations thereof.

The non-transitory software program and instructions required to implement the data processing method are stored in the memory 920 which, when executed by one or more processors 910, cause the one or more processors 910 to implement the data processing method according to any one of the embodiments of the present disclosure.

An embodiment of the present disclosure provides a computer-readable storage medium, having a processor-executable program stored therein. The processor-executable program, when executed by a processor, causes the processor to implement the data processing method according to any one of the above embodiments.

The computer-readable storage medium in the embodiment of the present disclosure may be any combination of one or more computer-readable media. The computer-readable medium may be a computer-readable signal medium or a computer-readable storage medium. For example, the computer-readable storage medium may include, but not limited to, an electrical, magnetic, optical, electromagnetic, infrared, or semiconductor system, apparatus, or device, or any combination thereof. Specific examples (not exhaustive) of the computer-readable storage medium include: an electrical connection having one or more wires, a portable computer disk, a hard disk, a Random Access Memory (RAM), a Read-Only Memory (ROM), an erasable programmable Read-Only Memory (EPROM), a flash memory, an optical fiber, a portable Compact Disc Read-Only Memory (CD-ROM), an optical storage device, a magnetic storage device, or any suitable combination thereof. In the present disclosure, the computer-readable storage medium may be any tangible medium containing or storing a program that may be used by or in combination with an instruction execution system, apparatus, or device.

The computer-readable signal medium may include a data signal propagated in a baseband or as part of a carrier. The data signal carries computer-readable program code. Such a propagated data signal may be in a variety of forms including, but not limited to, an electromagnetic signal, an optical signal, or any suitable combination thereof. The computer-readable signal medium may also be any computer-readable medium other than a computer-readable storage medium, and may send, propagate, or transmit a program for use by or in combination with an instruction execution system, apparatus, or device.

The program code contained on the computer-readable medium may be transmitted using any suitable medium, including but not limited to, via wireless transmission, via a wire, via a fiber optic cable, via Radio Frequency (RF), etc., or any suitable combination thereof.

Computer program code for executing the operations of the present disclosure may be compiled in one or more programming languages or a combination of programming languages, including objectoriented programming languages such as Java, Smalltalk, and C++, and conventional procedural programming languages such as the "C" language or similar programming languages. The program code can be entirely executed on a user's computer, partly executed on the user's computer, executed as a separate software package, partly executed on the user's computer and partly executed on a remote computer, or entirely executed on a remote computer or server. In cases involving a remote computer, the remote computer may be connected to the user's computer via any type of network, including a Local Area Network (LAN) or a Wide Area Network (WAN), or may be connected to an external computer (e.g., via an Internet service provided by an Internet service provider).

An embodiment of the present disclosure provides a computer program product, storing computer instructions which, when executed by a computer, cause the computer to implement the data processing method according to any one of the above embodiments.

Although some embodiments of the present disclosure have been described above, the present disclosure is not limited to the implementations described above. Those having ordinary skills in the art can make various equivalent modifications or replacements without departing from the scope of the present disclosure. Such equivalent modifications or replacements fall within the scope defined by the claims of the present disclosure.

**Claims**

1. A data processing method, comprising:

   acquiring an information bit sequence, wherein the information bit sequence comprises K information bits, and K is an integer greater than 0;
   encoding the information bit sequence according to at least one of a first encoding parameter, a quantization weight value sequence, and a reliability threshold to obtain an encoded data sequence, wherein the encoded data sequence comprises N pieces of encoded data, N is an integer greater than K, the quantization weight value sequence comprises n quantization weight values, N represents a number of polarized subchannels, and N is less than or equal to an $n^{th}$ power of 2; and
   sending the encoded data sequence.

2. The method of claim 1, wherein the n quantization weight values in the quantization weight value sequence are arranged in ascending order or descending order.

3. The method of claim 1, wherein a $j^{th}$ quantization weight value in the quantization weight value sequence represents a quantization weight value corresponding to a $j^{th}$ bit in a binary expression of a subchannel index number, and j is any integer from 0 to (n-1).

4. The method of claim 3, wherein a sum of all quantization weight values in the quantization weight value sequence is less than a first value, wherein the first value is a positive integer power of 2.

5. The method of claim 4, wherein the first value comprises one of: 256, 512, 1024, 2048, or 4096.

6. The method of claim 4, wherein the quantization weight value sequence is determined by at least one of:

   presetting the quantization weight value sequence; or
   determining the quantization weight value sequence according to a constraint condition that a number of differences between a quantized polar weight sequence obtained by the quantization weight value sequence and a polar weight sequence is not greater than a second value, wherein the second value is an integer greater than or equal to 0 and less than or equal to N.

7. The method of claim 4, wherein the quantization weight value sequence comprises one of:

β = [96, 81, 68, 57, 48, 40, 34, 28, 24, 20]; or
β = [197, 165, 139, 116, 98, 82, 68, 58, 49, 41]; or
β = [389, 327, 275, 231, 194, 163, 137, 115, 97, 82]; or
β = [780, 656, 552, 464, 390, 328, 276, 232, 195, 164]; or
β = [51, 43, 36, 30, 25, 21, 18, 15, 13]; or
β = [101, 85, 71, 60, 50, 42, 35,30, 25]; or
β = [206, 173, 145, 122, 102, 86, 73, 61, 51]; or
β = [480, 404, 340, 286, 240, 202, 170, 143, 120];

wherein β represents the quantization weight value sequence.

8. The method of claim 1, wherein the reliability threshold is obtained from a preset mapping relationship according to an index value, the index value is determined according to at least one of a value of K, a value of N, and a value of a code rate R, and the mapping relationship comprises at least one of: a mapping formula, a mapping table, or a mapping graph.

9. The method of claim 8, wherein the reliability threshold is obtained from the mapping table according to the index value, wherein the index value is determined according to the value of K and the value of N.

10. The method of claim 9, wherein a value of N corresponds to two different values of K, K1 and K2, and when K1 is less than K2, $w_{K1,N}$ is greater than $w_{K2,N}$, wherein $w_{K1,N}$ represents a reliability threshold corresponding to the value of K1 and the value of N, and $w_{K2,N}$ represents a reliability threshold corresponding to the value of K2 and the value of N; and a value of K corresponds to two different values of N, N1 and N2, and when N1 is less than N2, $w_{K,N1}$ is less than $w_{K,N2}$, wherein $w_{K,N1}$ represents a reliability threshold corresponding to the value of K and the value of N1, and $w_{K,N2}$ represents a reliability threshold corresponding to the value of K and the value of N2.

11. The method of claim 9, wherein the reliability threshold is determined by:
calculating a subchannel reliability value corresponding to each of the polarized subchannels according to a quantization weight value sequence β and subchannel index numbers i respectively corresponding to the polarized subchannels, obtaining a subchannel reliability sequence according to the subchannel reliability values corresponding to the N polarized subchannels, selecting K largest subchannel reliability values from the subchannel reliability sequence, and selecting the smallest subchannel reliability value as the reliability threshold from the K largest subchannel reliability values.

12. The method of claim 8, wherein the reliability threshold is obtained from the mapping table according to the index value, wherein the index value is determined according to the value of K and the value of R.

13. The method of claim 12, wherein a value of K corresponds to two different values of R, R1 and R2, and when R1 is less than R2, $w_{K,R1}$ is greater than $w_{K,R2}$, wherein $w_{K,R1}$ represents a reliability threshold corresponding to the value of K and the value of R1, and $w_{K,N2}$ represents a reliability threshold corresponding to the value of K and the value of R2.

14. The method of claim 12, wherein the reliability threshold is determined by:
determining the value of N according to the value of K and the value of R, calculating a subchannel reliability value corresponding to each of the polarized subchannels according to a quantization weight value sequence β and subchannel index numbers i respectively corresponding to the polarized subchannels, obtaining a subchannel reliability sequence according to the subchannel reliability values corresponding to the N polarized subchannels, selecting K largest subchannel reliability values from the subchannel reliability sequence, and selecting the smallest subchannel reliability value as the reliability threshold from the K largest subchannel reliability values.

15. The method of claim 1, wherein encoding the information bit sequence according to at least one of a first encoding parameter, a quantization weight value sequence, and a reliability threshold to obtain an encoded data sequence, comprises:

adding frozen bits to the information bit sequence according to at least one of a first encoding parameter, a quantization weight value sequence, and a reliability threshold to obtain an encoded data sequence to obtain an information and frozen bit sequence, wherein the information and frozen bit sequence comprises N bits; and encoding the information and frozen bit sequence to obtain the encoded data sequence.

16. The method of claim 15, wherein the information bit sequence is expressed as a formula a = [$a_0$, $a_1$, ..., $a_{K-1}$], the information and frozen bit sequence is expressed as a formula u = [$u_0$, $u_1$, ..., $u_{N-1}$], and the information bit sequence and the information and frozen bit sequence satisfy the following mapping relationship: $u_{fl(j)} = a_{f2(j)}$, wherein fl(j) $\in$ {0, 1, ..., N-1}, f2(j) $\in$ {0, 1, ..., K-1}, and j = 0, 1, ..., K-1.

17. The method of claim 16, wherein f1 is a function of j, and is determined according to f2(j), an information and frozen bit indication, and an information index number; and f2 is a function of j, and comprises f(j)=j or f(j)=K-j.

18. The method of claim 15, wherein adding frozen bits to the information bit sequence according to at least one of a first encoding parameter, a quantization weight value sequence, and a reliability threshold to obtain an encoded data sequence to obtain an information and frozen bit sequence comprises:

   adding frozen bits to the information bit sequence according to a preset rule to obtain an initial information and frozen bit sequence, wherein the information and frozen bit sequence comprises N bits; and
   sequentially traversing the N polarized subchannels in ascending order or descending order of subchannel index numbers, and performing the following processing for the polarized subchannel currently being traversed: determining a subchannel reliability value of the polarized subchannel currently being traversed according to the quantization weight value sequence, determining a frozen bit indication corresponding to the polarized subchannel currently being traversed according to the reliability threshold and the subchannel reliability value, determining a value of a bit, which corresponds to the polarized subchannel currently being traversed, in the information and frozen bit sequence according to the frozen bit indication, and updating the information and frozen bit sequence according to the value of the bit.

19. The method of claim 15, wherein encoding the information and frozen bit sequence to obtain an encoded data sequence comprises:

   acquiring an n-stage serial encoder, wherein the n-stage serial encoder is configured for performing n-stage serial encoding, and in each stage of serial computing, bits in the information and frozen bit sequence are encoded in groups of two; and wherein the two bits are respectively expressed as a $k0^{th}$ bit and a $k1^{th}$ bit, k0 represents a decimal number obtained by exchanging a $j^{th}$ bit and a lowest bit of a subchannel i, k1 represents a decimal number obtained by exchanging a $j^{th}$ bit and a lowest bit of a subchannel i+1, i $\in$ {0, 2, 4, ..., N-2}, j represents a serial encoding stage, j $\in$ {0, 1, 2, ..., n-1}, and n=$\log_2 N$; and
   encoding the information and frozen bit sequence by using the n-stage serial encoder to obtain the encoded data sequence.

20. The method of claim 1, wherein the first encoding parameter comprises at least one of: an information bit sequence size, a code rate, the number of polarized subchannels, an information index number, a subchannel index number, a polar coding stage index number, a number of transport block bits, a number of cyclic redundancy check bits, or a number of parity check bits.

21. A data processing method, comprising:
   receiving an encoded data sequence sent by a transmit end, wherein the encoded data sequence is obtained by: encoding an information bit sequence according to at least one of a first encoding parameter, a quantization weight value sequence, and a reliability threshold to obtain the encoded data sequence, wherein the information bit sequence comprises K information bits, K is an integer greater than 0, the encoded data sequence comprises N pieces of encoded data, N is an integer greater than K, the quantization weight value sequence comprises n quantization weight values, N represents a number of polarized subchannels, and N is less than or equal to an $n^{th}$ power of 2.

22. A data processing apparatus, comprising at least one of:

   a reliability threshold memory, configured for storing a reliability threshold;
   a subchannel and stage calculator, configured for outputting a current subchannel index number and a current stage index number;
   a quantization weight value sequence memory, configured for storing a quantization weight value sequence;
   a subchannel reliability calculator, configured for determining a subchannel reliability value according to the quantization weight value sequence and the subchannel index number;
   a reliability comparator, configured for comparing the subchannel reliability value with the reliability threshold, and outputting an information and frozen bit indication according to a result of the comparison;

an information bit index calculator, configured for outputting an information bit index according to a number of information bits, a number of polarized subchannels, and the information and frozen bit indication;

an encoded bit information memory, configured for receiving and storing an information bit sequence which is inputted, determining an information and frozen bit sequence according to the information bit sequence and the information and frozen bit indication, and storing the information and frozen bit sequence; and

a serial encoder, configured for serially encoding the information and frozen bit sequence, and outputting an encoded data sequence,

wherein the encoded bit information memory is further configured for storing the encoded data sequence.

23. An electronic device, comprising:

at least one processor; and
at least one memory, configured for storing at least one program,
wherein the at least one program, when executed by the at least one processor, causes the at least one processor to perform the data processing method of any one of claims 1 to 21.

24. A computer-readable storage medium, storing a processor-executable program, wherein the processor-executable program, when executed by a processor, causes the processor to perform the data processing method of any one of claims 1 to 21.

25. A computer program product, comprising a computer program or a computer instruction stored in a computer-readable storage medium, wherein the computer program or computer instruction, when read from the computer-readable storage medium and executed by a processor of a computer device, causes the computer device to perform the data processing method of any one of claims 1 to 21.

```
k = 0;
For i = 0, 1, 2,..., N-1
        u_i = 0;
        If i ∈ Q
                u_i = a_k;
                k = k + 1;
        End
End
```

FIG. 1a

FIG. 1b

## FIG. 2

Acquire an information bit sequence, where the information bit sequence includes K information bits, and K is an integer greater than 0 — S100

Encode the information bit sequence according to at least one of a first encoding parameter, a quantization weight value sequence, and a reliability threshold to obtain an encoded data sequence, where the encoded data sequence includes N pieces of encoded data, N is an integer greater than K, the quantization weight value sequence includes n quantization weight values, N represents a number of polarized subchannels, and N is less than or equal to an $n^{th}$ power of 2 — S200

Send the encoded data sequence — S300

## FIG. 3

```
k = K - 1;
u = [a_0, a_1,..., a_{K-1},0,...,0];
For i = N-1, N-2, N-3,..., 1, 0
    If   F = 1 && k ≥ 0
        u_i = u_k;
        k = k - 1;
    Else
        u_i = 0;
    End
End
```

## FIG. 4

```
k = N - K;
u = [0,...,0,a_0, a_1,..., a_{K-1}];
For i = 0, 1, 2,..., N-1
    If   F = 1 && k ≤ N-1
        u_i = u_k;
        k = k + 1;
    Else
        u_i = 0;
    End
End
```

## FIG. 5

```
k = K - 1;
u = [a_{K-1}, a_{K-2},..., a_0,0,...,0];
For i = N-1, N-2, N-3,..., 1, 0
        If   F = 1 && k ≥ 0
                u_i = u_k;
                k = k - 1;
        Else
                u_i = 0;
        End
End
```

FIG. 6

```
k = N - K;
u = [0,...,0,a_{K-1}, a_{K-2},..., a_0];
For i = 0, 1, 2,..., N-1
        If   F = 1 && k ≤ N-1
                u_i = u_k;
                k = k + 1;
        Else
                u_i = 0;
        End
End
```

FIG. 7

```
For j = 0, 1, 2,..., n-1
   For i = 0, 2, 4,..., N-2
      k0 = exchange a j^{th} bit and a lowest bit of i
      k1 = exchange a j^{th} bit and a lowest bit of i+1
      u_{k0} = (u_{k0} + u_{k1}) mod 2;
   End
End
```

FIG. 8

```
For j = 0, 1, 2,..., n-1
   For i = N-2, N-4, N-6,..., 0
      k0 = exchange a j^{th} bit and a lowest bit of i
      k1 = exchange a j^{th} bit and a lowest bit of i+1
      u_{k0} = (u_{k0} + u_{k1}) mod 2;
   End
End
```

FIG. 9

| First transmission node | | Second transmission node |
|---|---|---|

S410: Receive an information bit sequence a, where $a=[a_0, a_1, ..., a_{K-1}]$

S420: Determine an information and frozen bit sequence u according to a first encoding parameter, a quantization weight value sequence, a reliability threshold, and the information bit sequence a, where $u = [u_0, u_1, ..., u_{N-1}]$

S430: Encode the information and frozen bit sequence u to obtain encoded data d, where $d = [d_0, d_1, ..., d_{N-1}]$

S440: Send encoded data d

FIG. 10

FIG. 11

FIG. 12

## INTERNATIONAL SEARCH REPORT

| International application No. |
|---|
| **PCT/CN2023/132939** |

### A. CLASSIFICATION OF SUBJECT MATTER

H03M13/13(2006.01)i

According to International Patent Classification (IPC) or to both national classification and IPC

### B. FIELDS SEARCHED

Minimum documentation searched (classification system followed by classification symbols)

IPC:H03M13

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: polar, 极化, 编码, 权重, 可靠度, 阈值, 信道, 索引, 映射, 冻结, 比特, encode, weight, reliability, threshold, channel, index, map, frozen, bit

### C. DOCUMENTS CONSIDERED TO BE RELEVANT

| Category* | Citation of document, with indication, where appropriate, of the relevant passages | Relevant to claim No. |
|---|---|---|
| X | CN 107666370 A (HUAWEI TECHNOLOGIES CO., LTD.) 06 February 2018 (2018-02-06) see description, paragraphs 89-126 | 1-3, 15-17, 20-21, 23-25 |
| X | CN 108809333 A (HUAWEI TECHNOLOGIES CO., LTD.) 13 November 2018 (2018-11-13) see description, paragraphs 180-275 | 1-3, 15-17, 20-21, 23-25 |
| A | CN 114157309 A (HUAZHONG UNIVERSITY OF SCIENCE AND TECHNOLOGY) 08 March 2022 (2022-03-08) entire document | 1-25 |
| A | CN 108347301 A (HUAWEI TECHNOLOGIES CO., LTD.) 31 July 2018 (2018-07-31) entire document | 1-25 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 February 2024** | **06 February 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/132939**

| Patent document cited in search report | | | Publication date (day/month/year) | Patent family member(s) | | | Publication date (day/month/year) |
|---|---|---|---|---|---|---|---|
| CN | 107666370 | A | 06 February 2018 | US | 2019165813 | A1 | 30 May 2019 |
| | | | | US | 10879932 | B2 | 29 December 2020 |
| | | | | WO | 2018019073 | A1 | 01 February 2018 |
| | | | | WO | 2018019044 | A1 | 01 February 2018 |
| | | | | CN | 107666370 | B | 22 September 2023 |
| CN | 108809333 | A | 13 November 2018 | EP | 3598649 | A1 | 22 January 2020 |
| | | | | EP | 3598649 | A4 | 22 July 2020 |
| | | | | US | 2020059246 | A1 | 20 February 2020 |
| | | | | US | 11063608 | B2 | 13 July 2021 |
| | | | | WO | 2018202195 | A1 | 08 November 2018 |
| | | | | IN | 201937034512 | A | 22 November 2019 |
| | | | | CN | 108809333 | B | 04 May 2021 |
| CN | 114157309 | A | 08 March 2022 | CN | 114157309 | B | 11 November 2022 |
| CN | 108347301 | A | 31 July 2018 | EP | 3567766 | A1 | 13 November 2019 |
| | | | | EP | 3567766 | A4 | 25 December 2019 |
| | | | | EP | 3567766 | B1 | 10 March 2021 |
| | | | | US | 2019349128 | A1 | 14 November 2019 |
| | | | | US | 11050508 | B2 | 29 June 2021 |
| | | | | WO | 2018137518 | A1 | 02 August 2018 |
| | | | | IN | 201937031875 | A | 11 October 2019 |
| | | | | CN | 108347301 | B | 02 June 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211557955